(19) Europäisches Patentamt
European Patent Office
Office européen des brevets

(11) EP 2 767 553 B1

# (12) EUROPEAN PATENT SPECIFICATION

(45) Date of publication and mention of the grant of the patent:
**15.03.2017 Bulletin 2017/11**

(21) Application number: **12838734.7**

(22) Date of filing: **28.09.2012**

(51) Int Cl.:
***H01L 51/46*** *(2006.01)* ***C08G 61/12*** *(2006.01)*
***C08K 3/04*** *(2006.01)* ***C08L 65/00*** *(2006.01)*
***G01J 1/02*** *(2006.01)* *H01L 51/42* *(2006.01)*

(86) International application number:
**PCT/JP2012/075878**

(87) International publication number:
**WO 2013/051676 (11.04.2013 Gazette 2013/15)**

## (54) POLYMER COMPOUND AND ELECTRONIC ELEMENT

POLYMERVERBINDUNG UND ELEKTRONISCHES ELEMENT

COMPOSÉ POLYMÈRE ET ÉLÉMENT ÉLECTRONIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **07.10.2011 JP 2011222675**

(43) Date of publication of application:
**20.08.2014 Bulletin 2014/34**

(73) Proprietor: **Sumitomo Chemical Company Limited**
**Tokyo 104-8260 (JP)**

(72) Inventors:
- **YOSHIMURA, Ken**
**Tsukuba-shi, Ibaraki 300-3294 (JP)**
- **OHYA, Kenichiro**
**Tsukuba-shi, Ibaraki 300-3294 (JP)**
- **KATO, Takehito**
**Tsukuba-shi, Ibaraki 300-3294 (JP)**

(74) Representative: **Duckworth, Timothy John**
**J A Kemp**
**14 South Square**
**Gray's Inn**
**London WC1R 5JJ (GB)**

(56) References cited:
**WO-A1-2004/039859 WO-A1-2008/140057**
**WO-A1-2009/051275 WO-A1-2011/052702**
**WO-A1-2011/052709 WO-A1-2011/052710**
**WO-A1-2011/052710 WO-A1-2011/052711**
**WO-A1-2011/052712 JP-A- 2008 109 114**
**US-A1- 2011 114 183**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

### Technical Field

The present invention relates to a polymer compound having a specific structure and an electronic device using the same.

### Background Art

In recent years, reduction of $CO_2$ released into atmospheric air is required for preventing global warming. For example, adoption of a solar system using a pn-junction type silicon-based solar battery and the like on a house roof is proposed, however, there is a problem that a single crystal, a polycrystal and amorphous silicon used in the above-described silicon-based solar battery need high temperature and high vacuum conditions in its production step.

In contrast, an organic film solar battery as an embodiment of organic photoelectric conversion devices can omit high temperature and high vacuum processes used in silicon-based solar battery production processes, and possibly can be produced at low cost by using only an application process, thus, attracts attention recently. As a polymer compound used in the organic film solar battery, a polymer compound composed of a repeating unit (A) and a repeating unit (B) is suggested (WO 2011/052709).

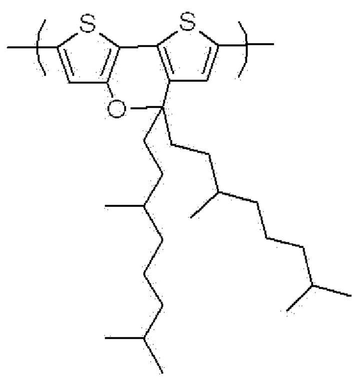

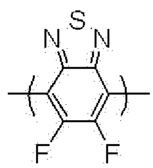

repeating unit (A) repeating unit (B)

An organic photoelectric conversion device having an organic layer containing the above-described polymer compound, however, shows not necessarily sufficient photoelectric conversion efficiency.

US-A-2011/114183 discloses polymer compounds and organic photoelectric converters using the same.
WO-A-2011/052710 discloses polymeric compounds which can be used in an organic layer in a photoelectric conversion element.

### Summary of the Invention

The present invention provides a polymer compound which, when used in an organic layer contained in an organic photoelectric conversion device, gives enhanced photoelectric conversion efficiency.

That is, the present invention provides a polymer compound comprising a constituent unit represented by the formula (1) and a constituent unit represented by the formula (2):

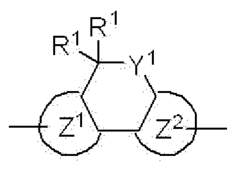

(1)

[wherein $R^1$ represents a branched alkyl group. $Y^1$ represents an oxygen atom, a sulfur atom or $-N(R^3)-$. $R^3$ represents a hydrogen atom or a substituent. Ring $Z^1$ and ring $Z^2$ represent each independently an optionally substituted aromatic carbocyclic ring or an optionally substituted heterocyclic ring.]

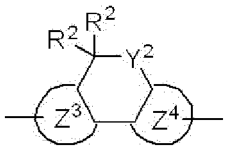

(2)

[wherein $R^2$ is different from $R^1$ and represents a linear alkyl group. $Y^2$ represents an oxygen atom, a sulfur atom or $-N(R^3)-$. $R^3$ represents a hydrogen atom or a substituent. Ring $Z^3$ and ring $Z^4$ represent each independently an optionally substituted aromatic carbocyclic ring or an optionally substituted heterocyclic ring.].

Also, the present invention provides the above-described polymer compound further comprising a constituent unit represented by the formula (3):

$-Ar^1-$ (3)

[wherein $Ar^1$ is different from the constituent unit represented by the formula (1) and the constituent unit represented by the formula (2) and represents an optionally substituted arylene group or an optionally substituted divalent heterocyclic group.].

Modes for Carrying Out the Invention

The present invention will be illustrated in detail below.

The polymer compound of the present invention is characterized by comprising a constituent unit represented by the formula (1) and a constituent unit represented by the formula (2).

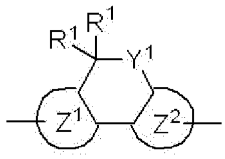

(1)

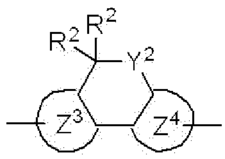

(2)

The alkyl group represented by $R^1$ is branched. The alkyl group has a number of carbon atoms of usually 1 to 30. The alkyl group may optionally have a substituent, and the substituent includes a halogen atom. Specific examples of the alkyl group include an isopropyl group, an isobutyl group, a sec-butyl group, a tert-butyl group, an isopentyl group, a 2-methylbutyl group, a 1-methylbutyl group, an isohexyl group, a 3-methylpentyl group, a 2-methylpentyl group, a 1-methylpentyl group, an isooctyl group, a 2-ethylhexyl group, and a 3,7-dimethyloctyl group. The alkyl group represented by $R^2$ is linear.

The alkyl group has a number of carbon atoms of usually 1 to 30. The alkyl group may optionally have a substituent, and the substituent includes a halogen atom. Specific examples of the alkyl group include linear alkyl groups such as a methyl group, an ethyl group, a propyl group, a butyl group, a pentyl group, a hexyl group, a heptyl group, an octyl group, a nonyl group, a decyl group, an undecyl group, a dodecyl group, a tetradecyl group, a hexadecyl group, an octadecyl group, and an eicosyl group.

The substituent represented by $R^3$ includes, for example, a halogen atom, an optionally substituted alkyl group, an optionally substituted alkoxy group, an optionally substituted alkylthio group, an optionally substituted aryl group, an optionally substituted aryloxy group, an optionally substituted arylthio group, an optionally substituted arylalkyl group, an optionally substituted arylalkoxy group, an optionally substituted arylalkylthio group, an acyl group, an acyloxy group, an amide group, an acid imide group, an imino group, an amino group, a substituted amino group, a substituted silyl group, a substituted silyloxy group, a substituted silylthio group, a substituted silylamino group, a heterocyclic group, a heterocyclic oxy group, a heterocyclic thio group, an optionally substituted arylalkenyl group, an optionally substituted arylalkynyl group, an optionally substituted carboxy group, a nitro group and a cyano group.

The halogen atom represented by $R^3$ includes a fluorine atom, a chlorine atom, a bromine atom and an iodine atom.

The alkyl group represented by $R^3$ may be linear, branched or cyclic. The alkyl group has a number of carbon atoms of usually 1 to 30. The alkyl group may optionally have a substituent, and the substituent includes a halogen atom. Specific examples of the alkyl group include linear alkyl groups such as a methyl group, an ethyl group, a propyl group,

an isopropyl group, a butyl group, an isobutyl group, a sec-butyl group, a tert-butyl group, a pentyl group, an isopentyl group, a 2-methylbutyl group, a 1-methylbutyl group, a hexyl group, an isohexyl group, a 3-methylpentyl group, a 2-methylpentyl group, a 1-methylpentyl group, a heptyl group, an octyl group, an isooctyl group, a 2-ethylhexyl group, a 3,7-dimethyloctyl group, a nonyl group, a decyl group, an undecyl group, a dodecyl group, a tetradecyl group, a hexadecyl group, an octadecyl group, an eicosyl group and the like, and cycloalkyl groups such as a cyclopentyl group, a cyclohexyl group, an adamantyl group and the like.

The alkyl portion of the alkoxy group represented by $R^3$ may be linear, branched or cyclic. The alkoxy group may optionally have a substituent. The alkoxy group has a number of carbon atoms of usually 1 to 20, and the substituent includes a halogen atom and an alkoxy group (having, for example, 1 to 20 carbon atoms). Specific examples of the optionally substituted alkoxy group include a methoxy group, an ethoxy group, a propoxy group, an isopropoxy group, a butoxy group, an isobutoxy group, a tert-butoxy group, a pentyloxy group, a hexyloxy group, a cyclohexyloxy group, a heptyloxy group, an octyloxy group, a 2-ethylhexyloxy group, a nonyloxy group, a decyloxy group, a 3,7-dimethyloctyloxy group, a lauryloxy group, a trifluoromethoxy group, a pentafluoroethoxy group, a perfluorobutoxy group, a perfluorohexyloxy group, a perfluorooctyloxy group, a methoxymethyloxy group and a 2-methoxyethyloxy group.

The alkyl portion of the alkylthio group represented by $R^3$ may be linear, branched or cyclic. The alkylthio group may optionally have a substituent. The alkylthio group has a number of carbon atoms of usually 1 to 20, and the substituent includes a halogen atom. Specific examples of the optionally substituted alkylthio group include a methylthio group, an ethylthio group, a propylthio group, an isopropylthio group, a butylthio group, an isobutylthio group, a tert-butylthio group, a pentylthio group, a hexylthio group, a cyclohexylthio group, a heptylthio group, an octylthio group, a 2-ethylhexylthio group, a nonylthio group, a decylthio group, a 3,7-dimethyloctylthio group, a laurylthio group and a trifluoromethylthio group.

The aryl group represented by $R^3$ denotes a group obtained by removing from an aromatic hydrocarbon one hydrogen atom on the aromatic ring, and has a number of carbon atoms of usually 6 to 60. The aryl group may optionally have a substituent, and the substituent includes a halogen atom and an alkoxy group (having, for example, 1 to 20 carbon atoms). Specific examples of the optionally substituted aryl group include a phenyl group, C1 to C12 alkoxyphenyl groups (The C1 to C12 alkoxy denotes an alkoxy having 1 to 12 carbon atoms. The C1 to C12 alkoxy is preferably a C1 to C8 alkoxy, more preferably a C1 to C6 alkoxy. The C1 to C8 alkoxy denotes an alkoxy having 1 to 8 carbon atoms, and the C1 to C6 alkoxy denotes an alkoxy having 1 to 6 carbon atoms. Specific examples of the C1 to C12 alkoxy, the C1 to C8 alkoxy and the C1 to C6 alkoxy include those explained and exemplified for the above-described alkoxy group. The same shall apply hereinafter.), C1 to C12 alkylphenyl groups (The C1 to C12 alkyl denotes an alkyl having 1 to 12 carbon atoms. The C1 to C12 alkyl is preferably a C1 to C8 alkyl, more preferably a C1 to C6 alkyl. The C1 to C8 alkyl denotes an alkyl having 1 to 8 carbon atoms, and the C1 to C6 alkyl denotes an alkyl having 1 to 6 carbon atoms. Specific examples of the C1 to C12 alkyl, the C1 to C8 alkyl and the C1 to C6 alkyl include those explained and exemplified for the above-described alkyl group. The same shall apply hereinafter.), a 1-naphthyl group, a 2-naphthyl group and a pentafluorophenyl group.

The aryloxy group represented by $R^3$ has a number of carbon atoms of usually 6 to 60, and the aryl portion may optionally have a substituent. The substituent includes a halogen atom and an alkoxy group (having, for example, 1 to 20 carbon atoms). Specific examples of the optionally substituted aryloxy group include a phenoxy group, C1 to C12 alkoxyphenoxy groups, C1 to C12 alkylphenoxy groups, a 1-naphthyloxy group, a 2-naphthyloxy group and a pentafluorophenyloxy group.

The arylthio group represented by $R^3$ has a number of carbon atoms of usually 6 to 60, and the aryl portion may optionally have a substituent. The substituent includes a halogen atom and an alkoxy group (having, for example, 1 to 20 carbon atoms). Specific examples of the optionally substituted arylthio group include a phenylthio group, C1 to C12 alkoxyphenylthio groups, C1 to C12 alkylphenylthio groups, a 1-naphthylthio group, a 2-naphthylthio group and a pentafluorophenylthio group.

The arylalkyl group represented by $R^3$ has a number of carbon atoms of usually 7 to 60, and the aryl portion may optionally have a substituent. The substituent includes a halogen atom and an alkoxy group (having, for example, 1 to 20 carbon atoms). Specific examples of the optionally substituted arylalkyl group include phenyl C1 to C12 alkyl groups, C1 to C12 alkoxyphenyl C1 to C12 alkyl groups, C1 to C12 alkylphenyl C1 to C12 alkyl groups, 1-naphthyl C1 to C12 alkyl groups and 2-naphthyl C1 to C12 alkyl groups.

The arylalkoxy group represented by $R^3$ has a number of carbon atoms of usually 7 to 60, and the aryl portion may optionally have a substituent. The substituent includes a halogen atom and an alkoxy group (having, for example, 1 to 20 carbon atoms). Specific examples of the optionally substituted arylalkoxy group include phenyl C1 to C12 alkoxy groups, C1 to C12 alkoxyphenyl C1 to C12 alkoxy groups, C1 to C12 alkylphenyl C1 to C12 alkoxy groups, 1-naphthyl C1 to C12 alkoxy groups and 2-naphthyl C1 to C12 alkoxy groups.

The arylalkylthio group represented by $R^3$ has a number of carbon atoms of usually 7 to 60, and the aryl portion may optionally have a substituent. The substituent includes a halogen atom and an alkoxy group (having, for example, 1 to 20 carbon atoms). Specific examples of the optionally substituted arylalkylthio group include phenyl C1 to C12

alkylthio groups, C1 to C12 alkoxyphenyl C1 to C12 alkylthio groups, C1 to C12 alkylphenyl C1 to C12 alkylthio groups, 1-naphthyl C1 to C12 alkylthio groups and 2-naphthyl C1 to C12 alkylthio groups.

The acyl group represented by $R^3$ denotes a group obtained by removing a hydroxyl group in a carboxylic acid, and has a number of carbon atoms of usually 2 to 20. Specific examples of the acyl group include alkylcarbonyl groups having 2 to 20 carbon atoms and optionally substituted by a halogen such as an acetyl group, a propionyl group, a butyryl group, an isobutyryl group, a pivaloyl group, a trifluoroacetyl group and the like, and phenylcarbonyl groups optionally substituted by a halogen such as a benzoyl group, a pentafluorobenzoyl group and the like.

The acyloxy group represented by $R^3$ denotes a group obtained by removing a hydrogen atom in a carboxylic acid, and has a number of carbon atoms of usually 2 to 20. Specific examples of the acyloxy group include an acetoxy group, a propionyloxy group, a butyryloxy group, an isobutyryloxy group, a pivaloyloxy group, a benzoyloxy group, a trifluoroacetyloxy group and a pentafluorobenzoyloxy group.

The amide group represented by $R^3$ denotes a group obtained by removing from amide ($-CONH_2$) one hydrogen atom linked to the nitrogen atom, and has a number of carbon atoms of usually 1 to 20. Specific examples of the amide group include a formamide group, an acetamide group, a propioamide group, a butyroamide group, a benzamide group, a trifluoroacetamide group, a pentafluorobenzamide group, a diformamide group, a diacetamide group, a dipropioamide group, a dibutyroamide group, a dibenzamide group, a ditrifluoroacetamide group and a dipentafluorobenzamide group.

The imide group represented by $R^3$ denotes a group obtained by removing from imide (-CO-NH-CO-) one hydrogen atom linked to the nitrogen atom, and specific examples thereof include a succinimide group and a phthalimide group.

The substituted amino group represented by $R^3$ denotes a group obtained by substitution of one or two hydrogen atoms of an amino group, and the substituent includes, for example, an optionally substituted alkyl group and an optionally substituted aryl group. Specific examples of the optionally substituted alkyl group and the optionally substituted aryl group are the same as specific examples of the optionally substituted alkyl group and the optionally substituted aryl group represented by R. The substituted amino group has a number of carbon atoms of usually 1 to 40. Specific examples of the substituted amino group include a methylamino group, a dimethylamino group, an ethylamino group, a diethylamino group, a propylamino group, a dipropylamino group, an isopropylamino group, a diisopropylamino group, a butylamino group, an isobutylamino group, a tert-butylamino group, a pentylamino group, a hexylamino group, a cyclohexylamino group, a heptylamino group, an octylamino group, a 2-ethylhexylamino group, a nonylamino group, a decylamino group, a 3,7-dimethyloctylamino group, a laurylamino group, a cyclopentylamino group, a dicyclopentylamino group, a cyclohexylamino group, a dicyclohexylamino group, a pyrrolidyl group, a piperidyl group, a ditrifluoromethylamino group, a phenylamino group, a diphenylamino group, C1 to C12 alkoxyphenylamino groups, di(C1 to C12 alkoxyphenyl)amino groups, di(C1 to C12 alkylphenyl)amino groups, a 1-naphthylamino group, a 2-naphthylamino group, a pentafluorophenylamino group, a pyridylamino group, a pyridazinylamino group, a pyrimidylamino group, a pyrazylamino group, a triazylamino group, phenyl C1 to C12 alkylamino groups, C1 to C12 alkoxyphenyl C1 to C12 alkylamino groups, C1 to C12 alkylphenyl C1 to C12 alkylamino groups, di(C1 to C12 alkoxyphenyl C1 to C12 alkyl)amino groups, di(C1 to C12 alkylphenyl C1 to C12 alkyl)amino groups, 1-naphthyl C1 to C12 alkylamino groups and 2-naphthyl C1 to C12 alkylamino groups.

The substituted silyl group represented by $R^3$ is a group obtained by substitution of one, two or three hydrogen atoms of a silyl group, in general, a group obtained by substitution of all three hydrogen atoms of a silyl group, and the substituent includes, for example, an optionally substituted alkyl group and an optionally substituted aryl group. Specific examples of the optionally substituted alkyl group and the optionally substituted aryl group are the same of specific examples of the optionally substituted alkyl group and the optionally substituted aryl group represented by $R^1$. Specific examples of the substituted silyl group include a trimethylsilyl group, a triethylsilyl group, a tripropylsilyl group, a triisopropylsilyl group, a tert-butyldimethylsilyl group, a triphenylsilyl group, a tri-p-xylylsilyl group, a tribenzylsilyl group, a diphenylmethylsilyl group, a tert-butyldiphenylsilyl group and a dimethylphenylsilyl group.

The substituted silyloxy group represented by $R^3$ is a group obtained by linking an oxygen atom to the above-described substituted silyl group. Specific examples of the substituted silyloxy group include a trimethylsilyloxy group, a triethylsilyloxy group, a tripropylsilyloxy group, a triisopropylsilyloxy group, a tert-butyldimethylsilyloxy group, a triphenylsilyloxy group, a tri-p-xylylsilyloxy group, a tribenzylsilyloxy group, a diphenylmethylsilyloxy group, a tert-butyldiphenylsilyloxy group and a dimethylphenylsilyloxy group.

The substituted silylthio group represented by $R^3$ is a group obtained by linking a sulfur atom to the above-described substituted silyl group. Specific examples of the substituted silylthio group include a trimethylsilylthio group, a triethylsilylthio group, a tripropylsilylthio group, a triisopropylsilylthio group, a tert-butyldimethylsilylthio group, a triphenylsilylthio group, a tri-p-xylylsilylthio group, a tribenzylsilylthio group, a diphenylmethylsilylthio group, a tert-butyldiphenylsilylthio group and a dimethylphenylsilylthio group.

The substituted silylamino group represented by $R^3$ is a group obtained by substitution of one or two hydrogen atoms of an amino group by a substituted silyl group, and the substituted silyl group is as described above. Specific examples of the substituted silylamino group include a trimethylsilylamino group, a triethylsilylamino group, a tripropylsilylamino group, a triisopropylsilylamino group, a tert-butyldimethylsilylamino group, a triphenylsilylamino group, a tri-p-xylylsilylamino group, a tribenzylsilylamino group, a diphenylmethylsilylamino group, a tert-butyldiphenylsilylamino group, a dimethylphenylsilylamino group, a di(trimethylsilyl)amino group, a di(triethylsilyl)amino group, a di(tripropylsilyl)amino group, a di(triisopropylsilyl)amino group, a di(tert-butyldimethylsilyl)amino group, a di(triphenylsilyl)amino group, a di(tri-p-xylylsilyl)amino group, a di(tribenzylsilyl)amino group, a di(diphenylmethylsilyl)amino group, a di(tert-butyldiphenylsilyl)amino group and a di(dimethylphenylsilyl)amino group.

The heterocyclic group represented by $R^3$ means a group obtained by removing one hydrogen atom from a heterocyclic compound such as optionally substituted furan, thiophene, pyrrole, pyrroline, pyrrolidine, oxazole, isoxazole, thiazole, isothiazole, imidazole, imidazoline, imidazolidine, pyrazole, pyrazoline, pyrazolidine, furazan, triazole, thiadiazole, oxadiazole, tetrazole, pyran, pyridine, piperidine, thiopyran, pyridazine, pyrimidine, pyrazine, piperazine, morpholine, triazine, benzofuran, isobenzofuran, benzothiophene, indole, isoindole, indolizine, indoline, isoindoline, chromene, chromane, isochromane, benzopyran, quinoline, isoquinoline, quinolizine, benzimidazole, benzothiazole, indazole, naphthyridine, quinoxaline, quinazoline, quinazolidine, cinnoline, phthalazine, purine, pteridine, carbazole, xanthene, phenanthridine, acridine, β-carboline, perimidine, phenanthroline, thianthrene, phenoxathiin, phenoxazine, phenothiazine, phenazine and the like. The heterocyclic group is preferably an aromatic heterocyclic group.

The heterocyclic oxy group represented by $R^3$ includes a group represented by the formula (4) obtained by linking an oxygen atom to the above-described heterocyclic group.

The heterocyclic thio group represented by $R^3$ includes a group represented by the formula (5) obtained by linking a sulfur atom to the above-described heterocyclic group.

$Ar^2$-O- (4)

$Ar^2$-S- (5)

[in the formulae (4) and (5), $Ar^2$ represents a heterocyclic group.].

The heterocyclic oxy group has a number of carbon atoms of usually 2 to 60. Specific examples of the heterocyclic oxy group include a thienyloxy group, C1 to C12 alkylthienyloxy groups, a pyrrolyloxy group, a furyloxy group, a pyridyloxy group, C1 to C12 alkylpyridyloxy groups, an imidazolyloxy group, a pyrazolyloxy group, a triazolyloxy group, an oxazolyloxy group, a thiazoleoxy group and a thiadiazoleoxy group.

The heterocyclic thio group has a number of carbon atoms of usually 2 to 60. Specific examples of the heterocyclic thio group include a thienylmercapto group, C1 to C12 alkylthienylmercapto groups, a pyrrolylmercapto group, a furylmercapto group, a pyridylmercapto group, C1 to C12 alkylpyridylmercapto groups, an imidazolylmercapto group, a pyrazolylmercapto group, a triazolylmercapto group, an oxazolylmercapto group, a thiazolemercapto group and a thiadiazolemercapto group.

The arylalkenyl group represented by $R^3$ has a number of carbon atoms of usually 8 to 20, and the aryl portion may optionally have a substituent. The substituent includes a halogen atom and an alkoxy group (having, for example, 1 to 20 carbon atoms). Specific examples of the arylalkenyl group include a styryl group.

The arylalkynyl group represented by $R^3$ has a number of carbon atoms of usually 8 to 20, and the aryl portion may optionally have a substituent. The substituent includes a halogen atom and an alkoxy group (having, for example, 1 to 20 carbon atoms). Specific examples of the arylalkynyl group include a phenylacetylenyl group.

In the carboxy group represented by $R^3$, a hydrogen atom in a carboxy group may be substituted with a substituent. The substituent includes, for example, an alkyl group having 1 to 20 carbon atoms. The substituted carboxy group includes, for example, a methoxycarbonyl group, an ethoxycarbonyl group and a propoxycarbonyl group.

In the formula (1), $Y^1$ represents an oxygen atom, a sulfur atom or -N($R^3$)-. $R^3$ represents a hydrogen atom or a substituent as defined above.

In the formula (2), $Y^2$ represents an oxygen atom, a sulfur atom or -N($R^3$)-.

In the formula (1), ring $Z^1$ and ring $Z^2$ represent each independently an optionally substituted aromatic carbocyclic ring or an optionally substituted heterocyclic ring.

The aromatic carbocyclic ring represented by ring $Z^1$ and ring $Z^2$ includes, for example, a benzene ring, a naphthalene ring, an anthracene ring, a phenanthrene ring, a pyrene ring, a perylene ring, a tetracene ring and a pentacene ring. The aromatic carbocyclic ring is preferably a benzene ring and a naphthalene ring, more preferably a benzene ring.

The heterocyclic ring represented by ring $Z^1$ and ring $Z^2$ includes, for example, a pyridine ring, a pyrimidine ring, a pyridazine ring, a pyrazine ring, a quinoline ring, an isoquinoline ring, a quinoxaline ring, a quinazoline ring, an acridine ring, a phenanthroline ring, a thiophene ring, a benzothiophene ring, a dibenzothiophene ring, a furan ring, a benzofuran ring, a dibenzofuran ring, a pyrrole ring, an indole ring, a dibenzopyrrole ring, a silole ring, a benzosilole ring, a dibenzosilole ring, a borole ring, a benzoborole ring and a dibenzoborole ring. A sulfur atom in a thiophene ring, a benzothiophene ring and a dibenzothiophene ring may be substituted with an oxo group to form a cyclic sulfoxide or a cyclic sulfone. The heterocyclic ring represented by ring $Z^1$ and ring $Z^2$ is preferably an aromatic heterocyclic ring. The

aromatic heterocyclic ring is preferably a thiophene ring, a furan ring or a pyrrole ring, more preferably a thiophene ring or a furan ring, further preferably a thiophene ring.

Specific examples of the substituent which the aromatic carbocyclic ring and the heterocyclic ring represented by ring $Z^1$ and ring $Z^2$ may optionally have include specific examples of the substituent represented by $R^3$.

In the formula (2), ring $Z^3$ and ring $Z^4$ represent each independently an optionally substituted aromatic carbocyclic ring or an optionally substituted heterocyclic ring. Specific examples of the aromatic carbocyclic ring and the heterocyclic ring represented by ring $Z^3$ and ring $Z^4$ are the same as specific examples of the aromatic carbocyclic ring and the heterocyclic ring represented by ring $Z^1$ and ring $Z^2$. The definition and specific examples of the substituent which the aromatic carbocyclic ring and the heterocyclic ring represented by ring $Z^3$ and ring $Z^4$ may optionally have are the same as the definition and specific examples of the substituent represented by $R^3$.

It is preferable that the aromatic carbocyclic ring and the heterocyclic ring represented by ring $Z^1$, ring $Z^2$, ring $Z^3$ and ring $Z^4$ have at least one substituent selected from the group consisting of an optionally substituted alkyl group, an optionally substituted alkoxy group, an optionally substituted aryloxy group and an optionally substituted aryl group, from the standpoint of enhancement of solubility of the polymer compound of the present invention in an organic solvent.

The constituent unit represented by the formula (1) includes constituent units represented by the formulae (301) to (375), and constituent units having a substituent on an
aromatic carbocyclic ring or an aromatic heterocyclic ring contained in these constituent units (301) to (375).

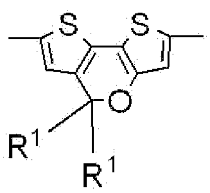
(301)

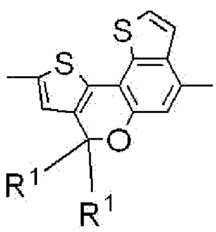
(302)

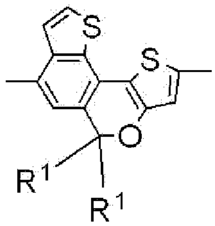
(303)

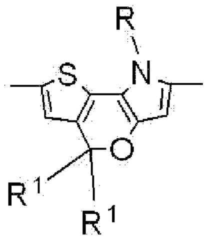
(304)

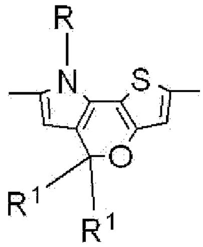
(305)

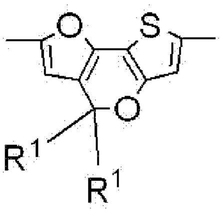
(306)

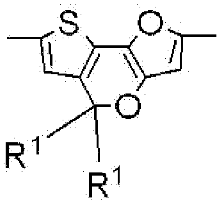
(307)

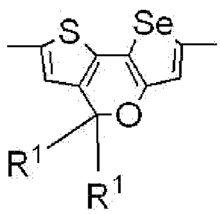
(308)

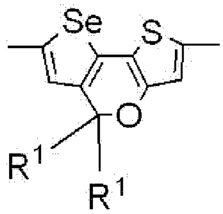
(309)

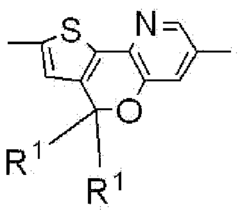
(310)

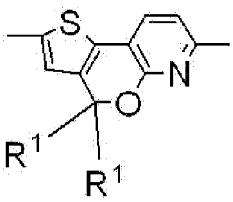
(311)

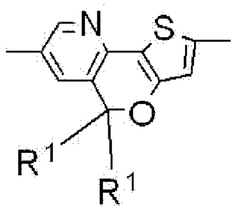
(312)

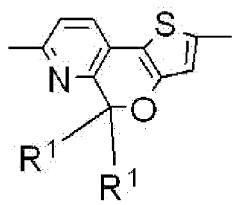
(313)

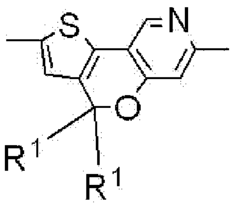

(314)

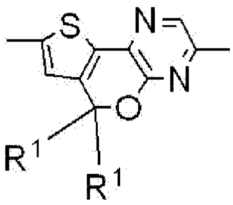

(315)

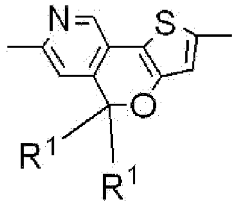

(316)

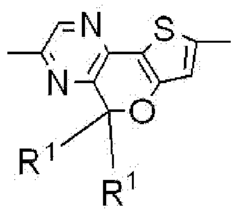

(317)

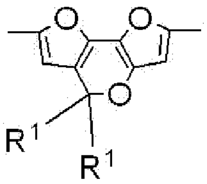

(318)

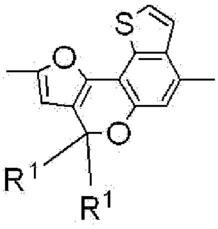

(319)

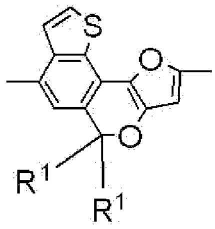

(320)

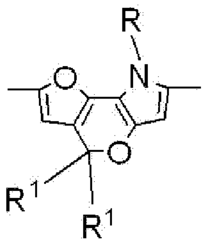

(321)

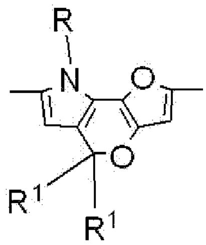

(322)

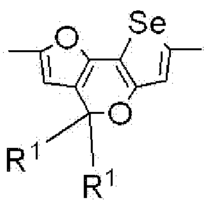

(323)

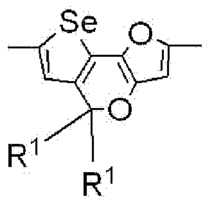

(324)

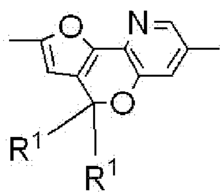

(325)

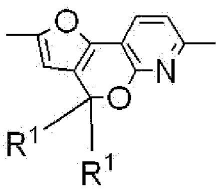

(326)

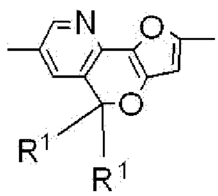

(327)

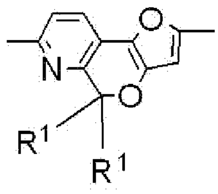

(328)

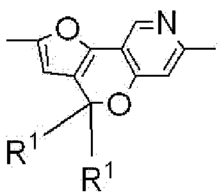

(329)

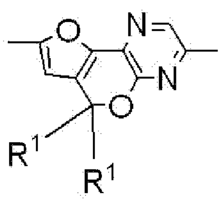

(330)

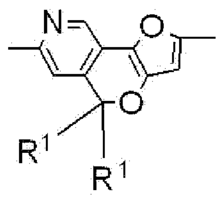

(331)

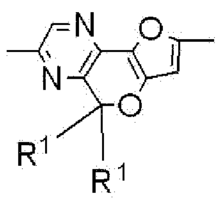

(332)

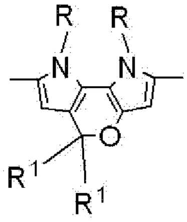
(333)

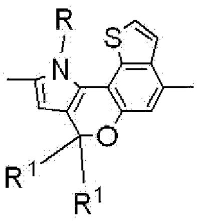
(334)

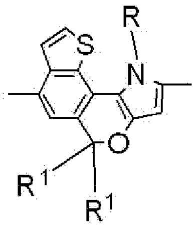
(335)

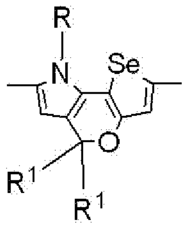
(336)

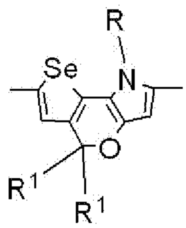
(337)

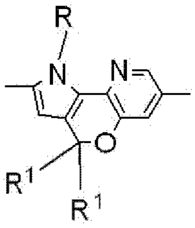
(338)

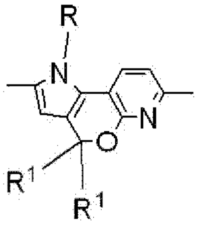
(339)

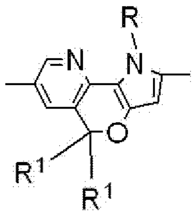
(340)

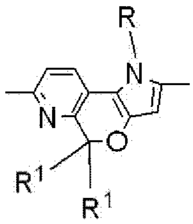
(341)

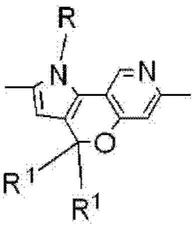
(342)

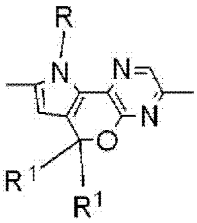
(343)

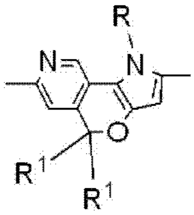
(344)

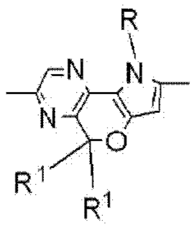
(345)

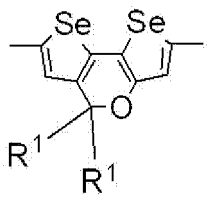
(346)

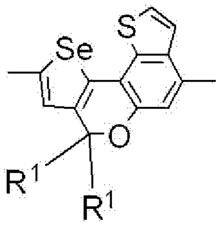
(347)

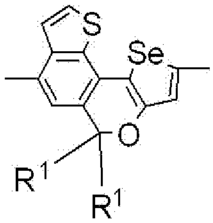
(348)

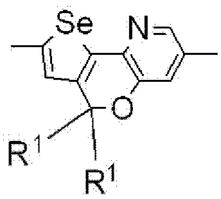
(349)

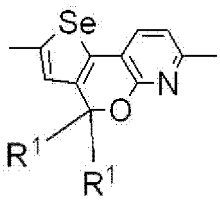
(350)

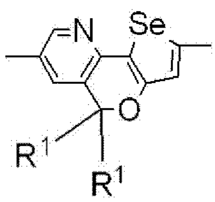
(351)

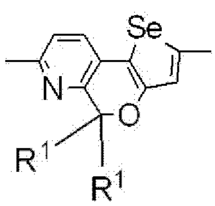
(352)

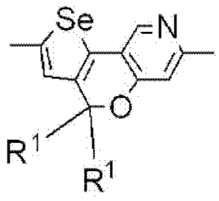
(353)

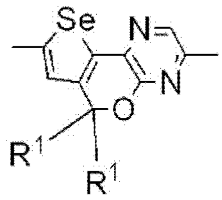
(354)

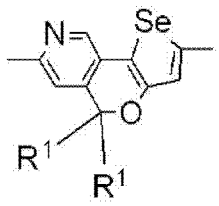
(355)

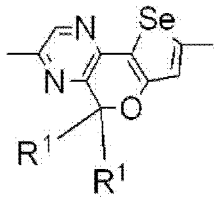
(356)

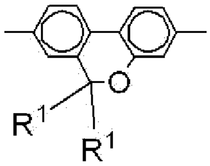
(357)

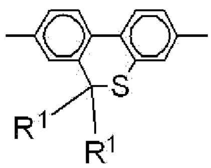
(358)

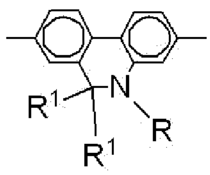
(359)

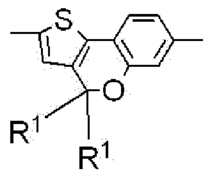
(360)

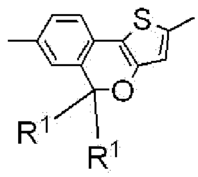
(361)

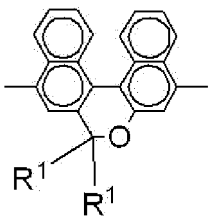
(362)

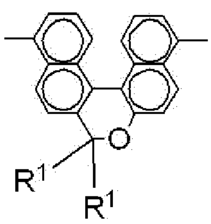
(363)

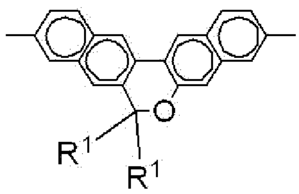
(364)

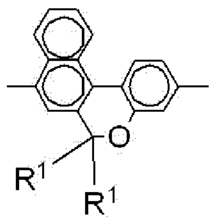
(365)

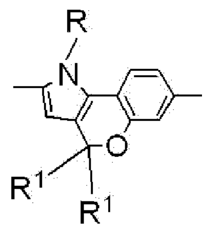
(366)

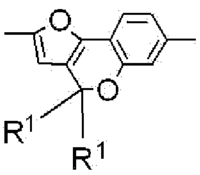
(367)

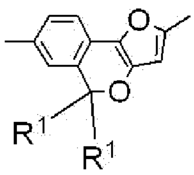
(368)

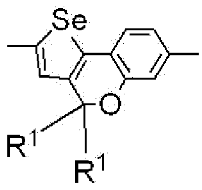
(369)

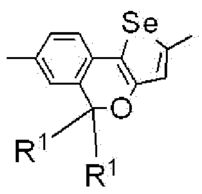
(370)

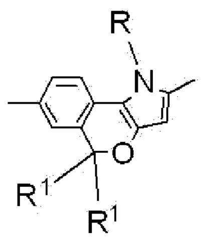
(371)

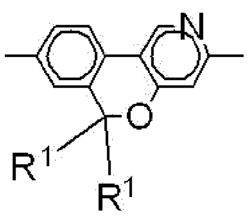
(372)

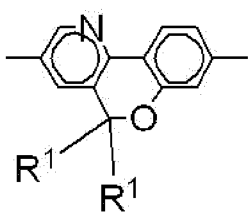
(373)

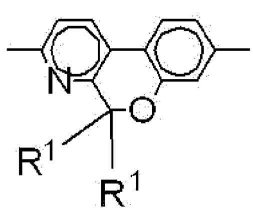
(374)

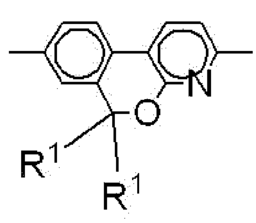
(375)

In the formulae (301) to (375), $R^1$ represents the same meaning as described above. R represents a hydrogen atom or a substituent. The definition and specific examples of the substituent represented by R are the same as the definition and specific examples of the substituent represented by $R^3$.

The constituent unit represented by the formula (2) includes constituent units represented by the formulae (401) to (475), and constituent units having a substituent on an aromatic carbocyclic ring or an aromatic heterocyclic ring

contained in these constituent units (401) to (475).

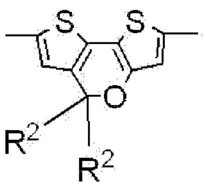
(401)

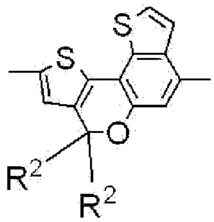
(402)

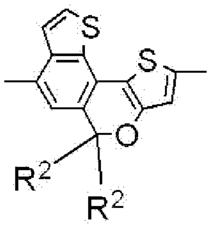
(403)

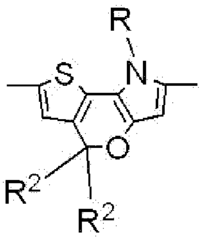
(404)

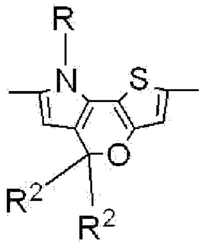
(405)

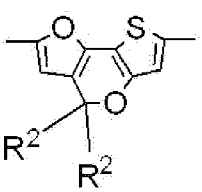
(406)

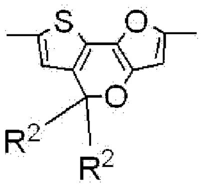
(407)

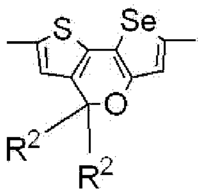
(408)

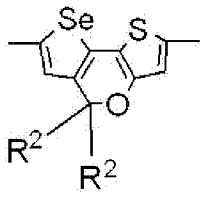
(409)

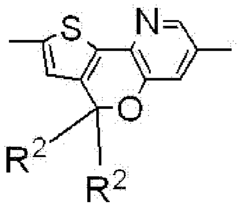
(410)

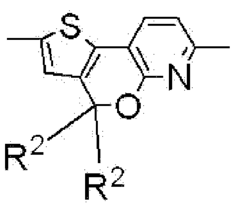
(411)

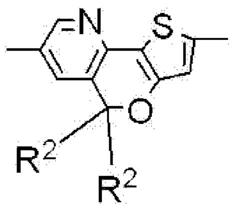
(412)

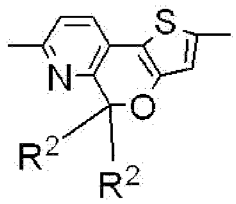
(413)

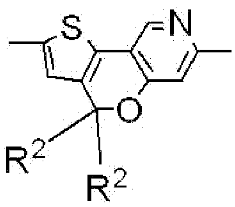
(414)

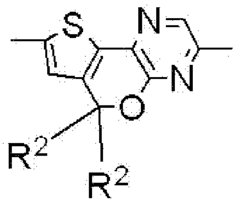
(415)

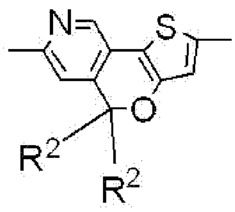
(416)

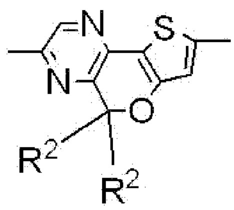
(417)

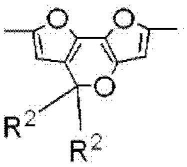
(418)

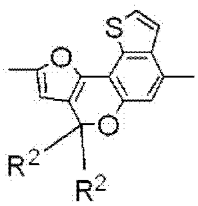
(419)

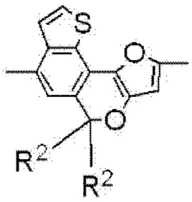
(420)

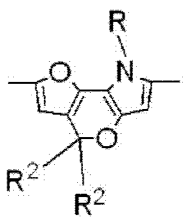
(421)

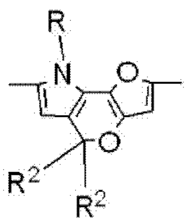
(422)

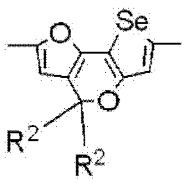
(423)

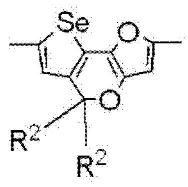
(424)

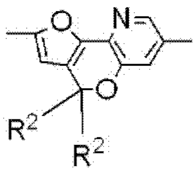
(425)

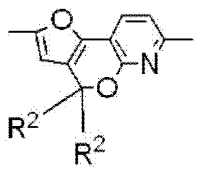
(426)

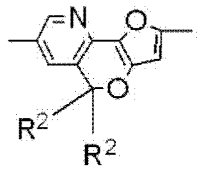
(427)

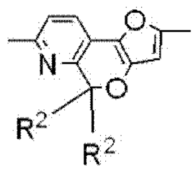
(428)

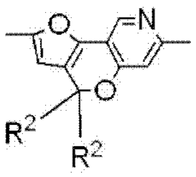
(429)

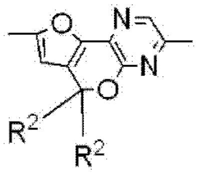
(430)

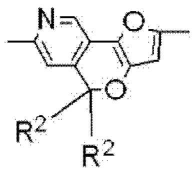
(431)

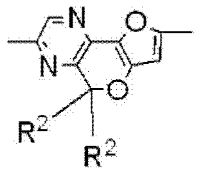
(432)

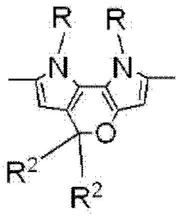
(433)

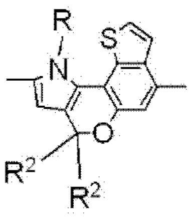
(434)

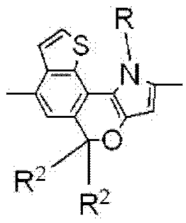
(435)

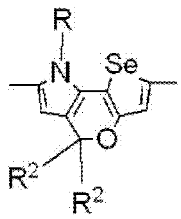
(436)

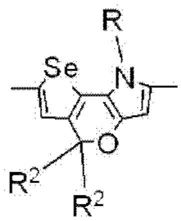
(437)

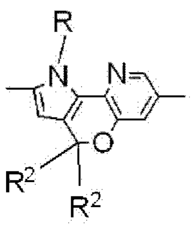
(438)

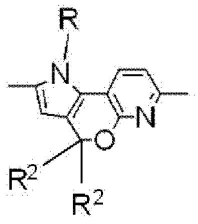
(439)

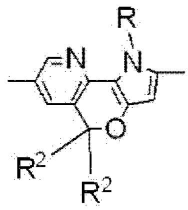
(440)

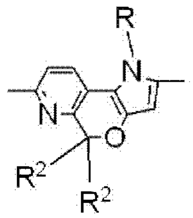
(441)

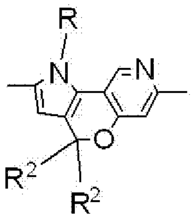
(442)

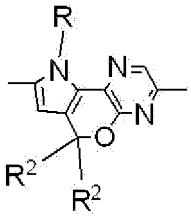
(443)

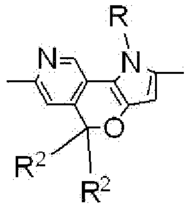
(444)

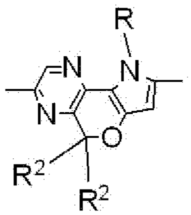
(445)

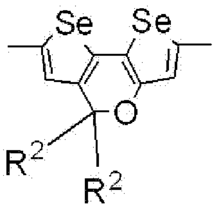
(446)

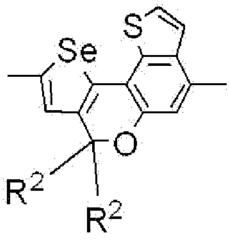
(447)

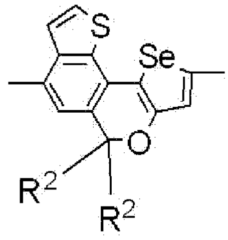
(448)

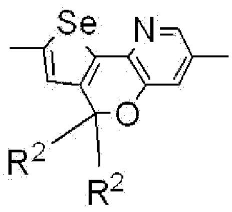
(449)

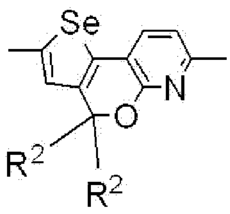
(450)

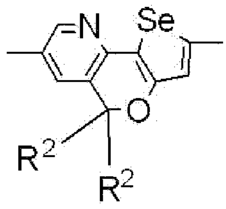
(451)

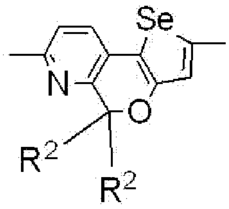
(452)

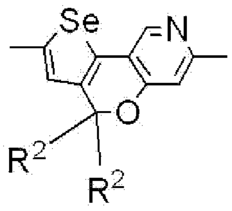
(453)

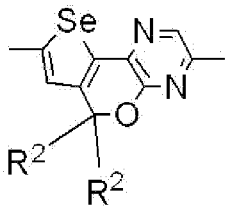
(454)

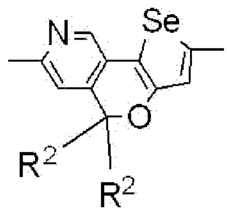
(455)

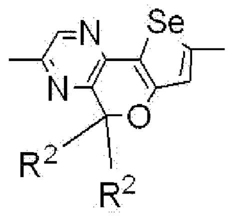
(456)

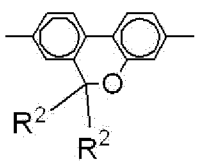
(457)

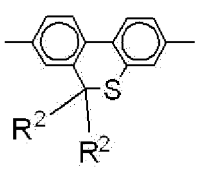
(458)

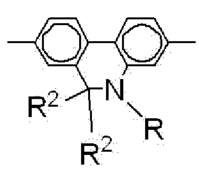
(459)

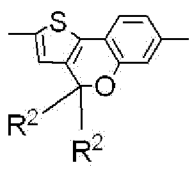
(460)

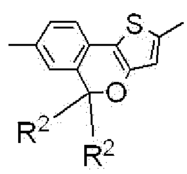
(461)

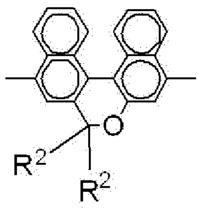
(462)

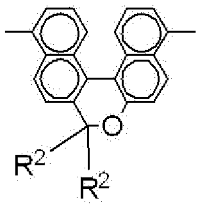
(463)

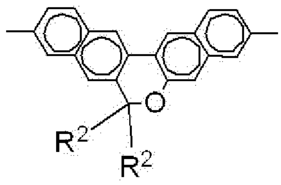
(464)

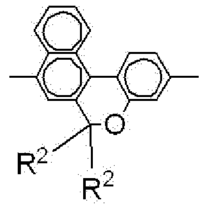
(465)

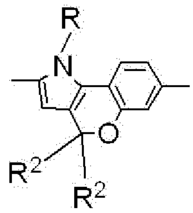
(466)

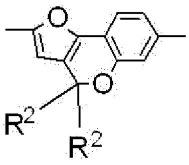
(467)

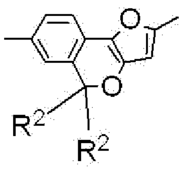
(468)

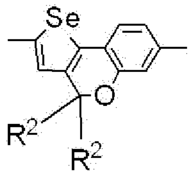
(469)

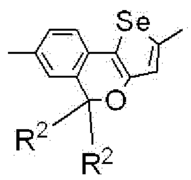
(470)

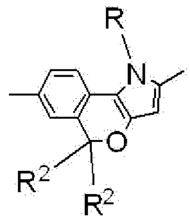
(471)

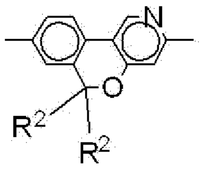
(472)

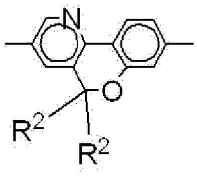
(473)

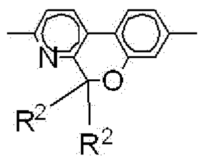
(474)

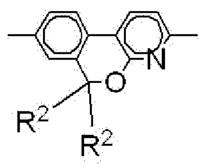
(475)

In the formulae (401) to (475), $R^2$ and R represent the same meaning as described above.

$R^1$ is a branched alkyl group and $R^2$ is a linear alkyl group from the standpoint of enhancement of the photoelectric conversion efficiency of an organic photoelectric conversion device containing the polymer compound of the present invention.

The constituent unit represented by the formula (1) in which $R^1$ is a branched alkyl group includes, for example, constituent units represented by the formulae (1-1) to (1-12).

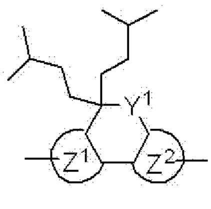
(1-1)

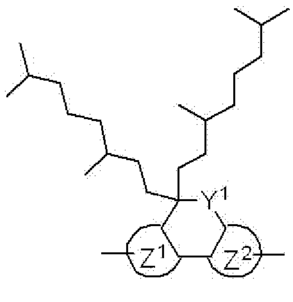
(1-2)

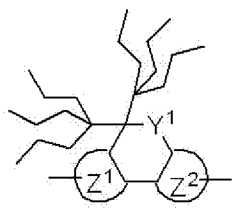
(1-3)

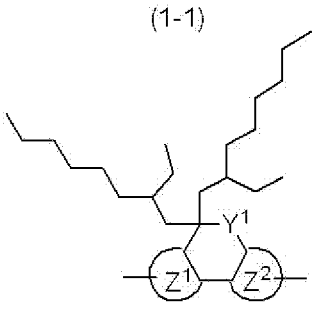
(1-4)

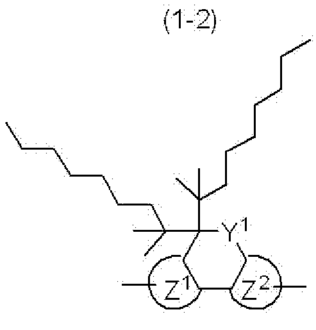
(1-5)

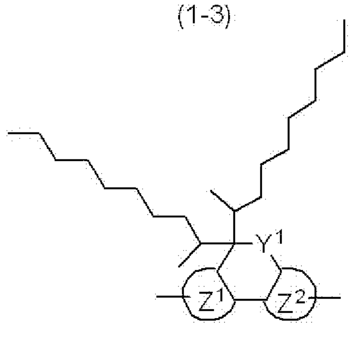
(1-6)

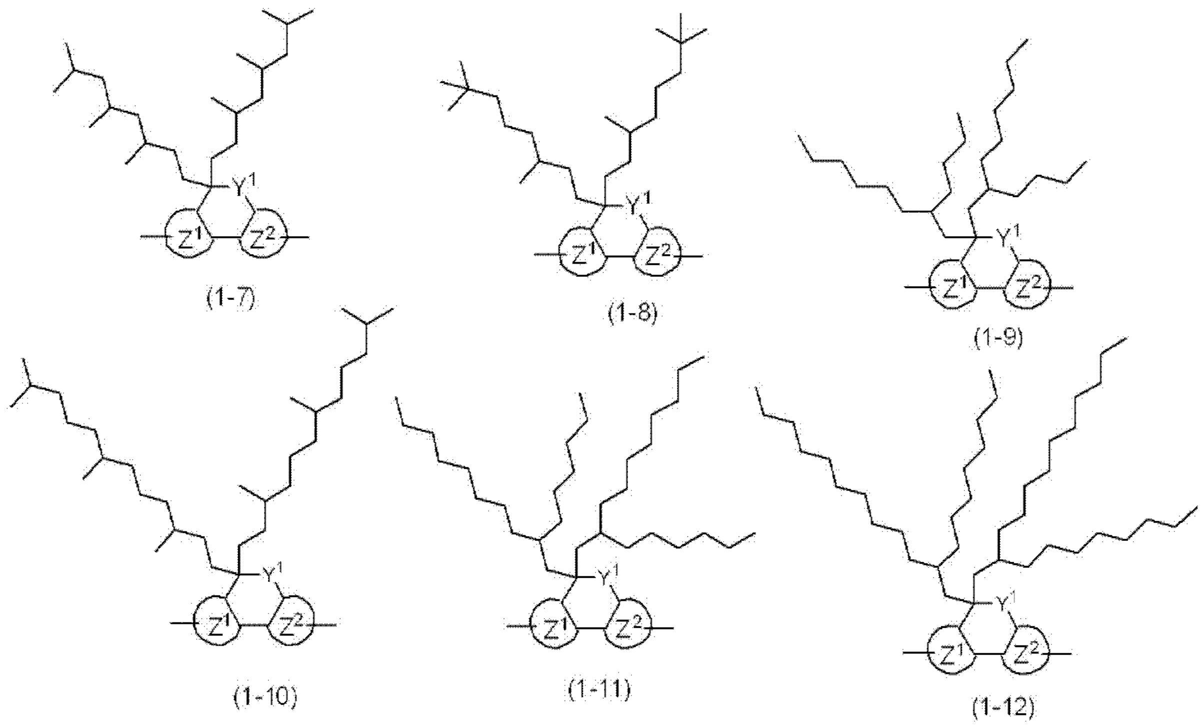

(1-7) (1-8) (1-9)

(1-10) (1-11) (1-12)

$R^1$ has a number of carbon atoms of preferably 5 to 20, more preferably 8 to 16, particularly preferably 10 to 15. Of constituent units represented by the formulae (1-1) to (1-12), constituent units represented by the formulae (1-2) to (1-10) are preferable.

The constituent unit represented by the formula (2) in which $R^2$ is a linear alkyl group includes, for example, constituent units represented by the formulae (2-1) to (2-8).

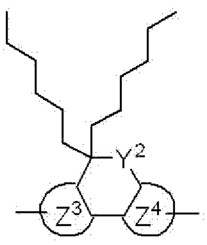

(2-1)

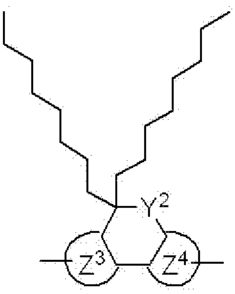

(2-2)

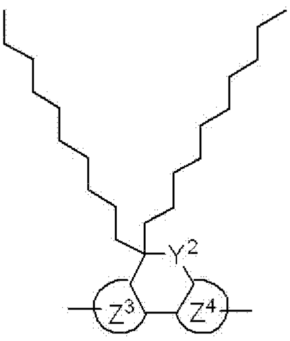

(2-3)

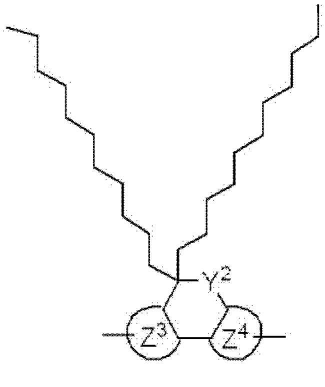

(2-4)

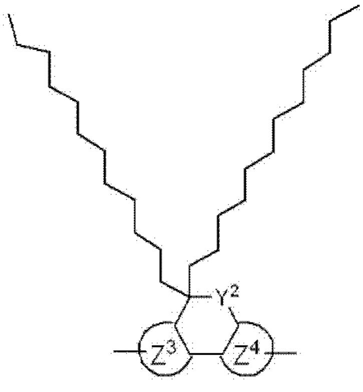

(2-5)

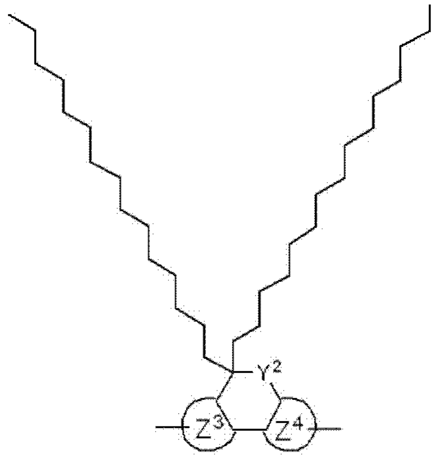

(2-6)

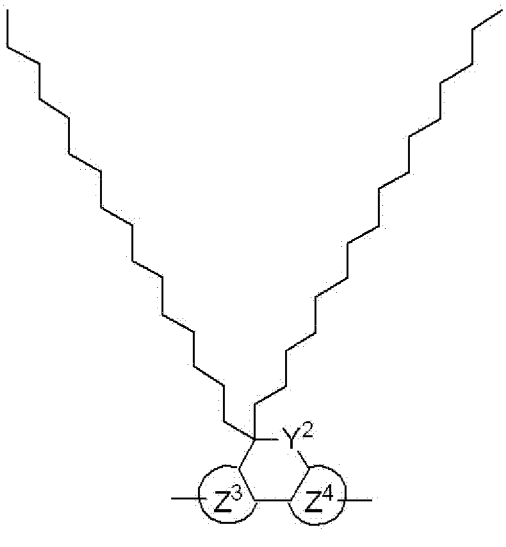

(2-7)

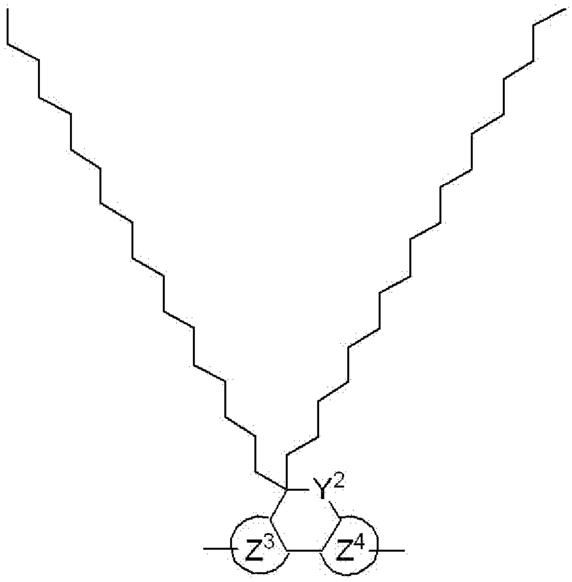

(2-8)

$R^2$ has a number of carbon atoms of preferably 6 to 20, more preferably 8 to 16, particularly preferably 10 to 15. Of the constituent units represented by the formulae (2-1) to (2-8), constituent units represented by the formulae (2-3) to (2-5) are preferable.

The polymer compound of the present invention may have the other constituent unit than the constituent unit represented by the formula (1) and the constituent unit represented by the formula (2). The other constituent unit includes, for example, a constituent unit represented by the formula (3).

$$-Ar^1- \qquad (3)$$

In the formula (3), $Ar^1$ is different from the constituent unit represented by the formula (1) and the constituent unit represented by the formula (2) and represents an optionally substituted arylene group or a divalent heterocyclic group.

The arylene group represented by $Ar^1$ denotes a group obtained by removing from an aromatic hydrocarbon two hydrogen atoms on the aromatic ring, and has a number of carbon atoms of usually 6 to 60. The arylene group may optionally have a substituent. The substituent includes, for example, a halogen atom and an alkoxy group (having, for example, 1 to 20 carbon atoms).

Exemplified as the optionally substituted arylene group are optionally substituted phenylene groups (for example, the following formulae 1 to 3), optionally substituted naphthalenediyl groups (the following formulae 4 to 13), optionally substituted anthracenediyl groups (the following formulae 14 to 19), optionally substituted biphenyldiyl groups (the

following formulae 20 to 25), optionally substituted terphenyldiyl groups (the following formulae 26 to 28), optionally substituted groups having a condensed ring structure (the following formulae 29 to 38) and the like. The group having a condensed ring structure includes fluorene-diyl groups (the following formulae 36 to 38).

The divalent heterocyclic group represented by $Ar^1$ denotes a group obtained by removing two hydrogen atoms from a heterocyclic compound such as optionally substituted furan, thiophene, pyrrole, pyrroline, pyrrolidine, oxazole, isooxazole, thiazole, isothiazole, imidazole, imidazoline, imidazolidine, pyrazole, pyrazoline, pyrazolidine, furazan, triazole, thiadiazole, oxadiazole, tetrazole, pyran, pyridine, piperidine, thiopyran, pyridazine, pyrimidine, pyrazine, piperazine, morpholine, triazine, benzofuran, isobenzofuran, benzothiophene, indole, isoindole, indolizine, indoline, isoindoline, chromene, chromane, isochromane, benzopyran, quinoline, isoquinoline, quinolizine, benzimidazole, benzothiazole, indazole, naphthyridine, quinoxaline, quinazoline, quinazolidine, cinnoline, phthalazine, purine, pteridine, carbazole, xanthene, phenanthridine, acridine, β-carboline, perimidine, phenanthroline, thianthrene, phenoxathiin, phenoxazine, phenothiazine, phenazine and the like. The divalent heterocyclic group may optionally have a substituent. The substituent includes, for example, a halogen atom and an alkoxy group (having, for example, 1 to 20 carbon atoms).

The divalent heterocyclic group includes, for example, the following groups.

Divalent heterocyclic groups containing nitrogen as a hetero atom: optionally substituted pyridinediyl groups (the following formulae 39 to 44).

Optionally substituted diazaphenylene groups (the following formulae 45 to 48).

Optionally substituted quinolinediyl groups (the following formulae 49 to 63).

Optionally substituted quinoxalinediyl groups (the following formulae 64 to 68).

Optionally substituted acridinediyl groups (the following formulae 69 to 72).

Optionally substituted bipyridyldiyl groups (the following formulae 73 to 75).

Optionally substituted phenanthrolinediyl groups (the following formulae 76 to 78).

Groups containing silicon, nitrogen, sulfur, selenium or the like as a hetero atom and having a fluorene structure (the following formulae 79 to 93).

5-membered ring heterocyclic groups containing silicon, nitrogen, sulfur, selenium or the like as a hetero atom (the following formulae 94 to 98).

5-membered ring condensed hetero groups containing silicon, nitrogen, sulfur, selenium or the like as a hetero atom (the following formulae 99 to 110).

5-membered ring heterocyclic groups containing silicon, nitrogen, sulfur, selenium or the like as a hetero atom and linking at an α-position of its hetero atom to form a dimer or an oligomer (the following formulae 111 to 112).

5-membered ring heterocyclic groups containing silicon, nitrogen, sulfur, selenium or the like as a hetero atom and linking at an α-position of its hetero atom to a phenyl group (the following formulae 113 to 119).

Groups containing a benzene ring and a thiophene ring mutually condensed (the following formulae 120 to 122).

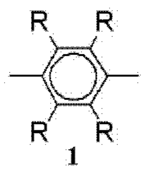
1
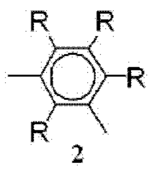
2
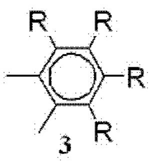
3

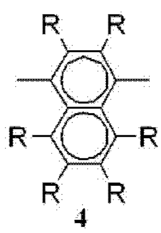
4
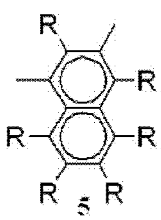
5
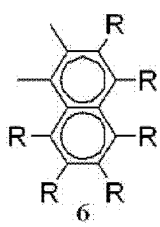
6
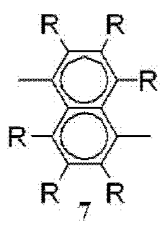
7

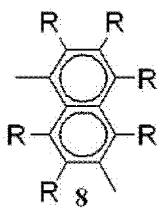
8
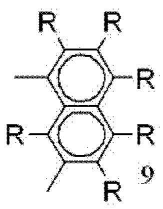
9
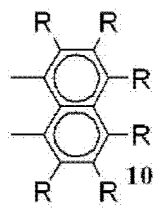
10
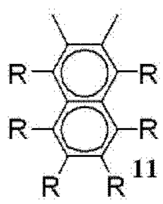
11

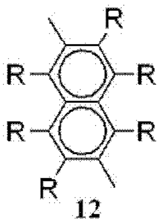
12

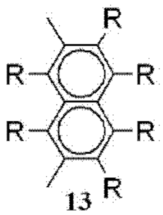
13

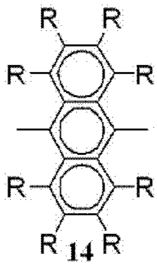
14

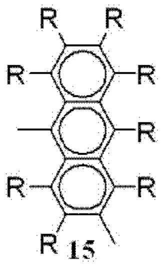
15

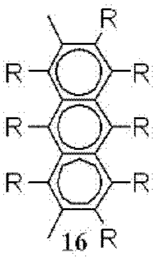
16

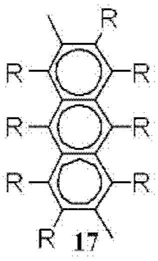
17

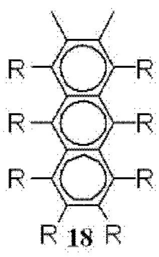
18

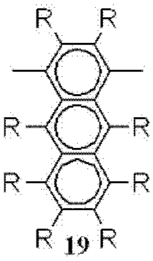
19

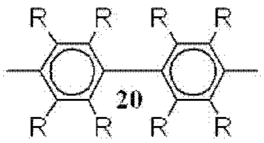
20

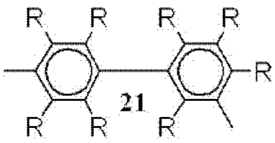
21

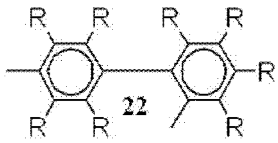
22

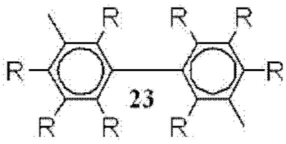
23

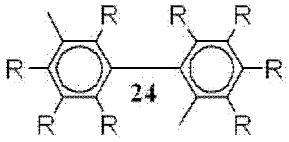
24

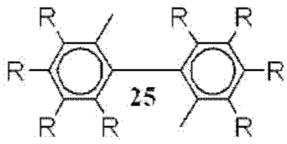
25

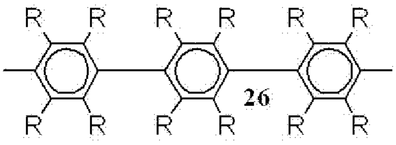
26

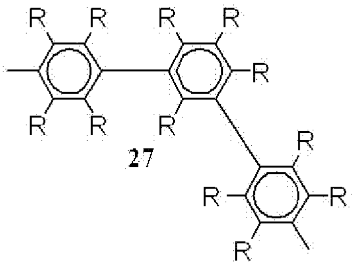
27

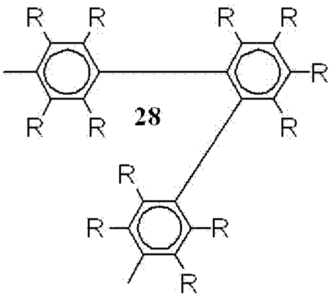
28

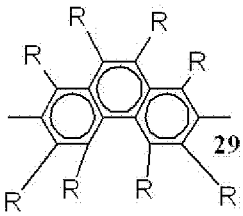
29

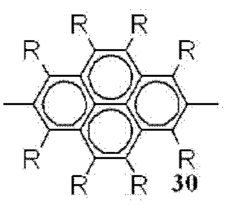
30

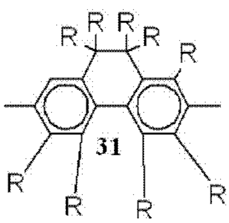
31

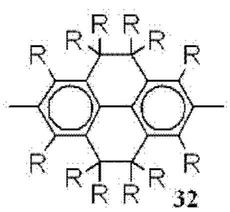
32

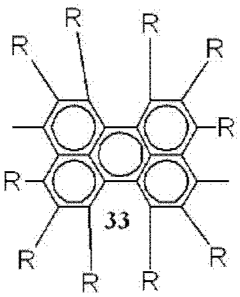 33

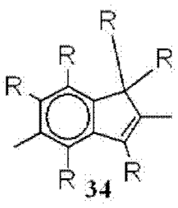 34

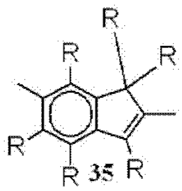 35

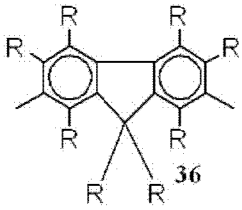 36

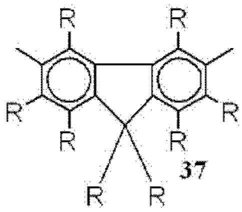 37

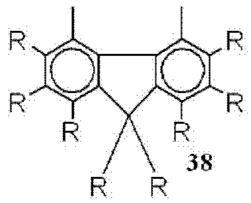 38

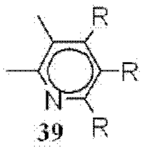 39

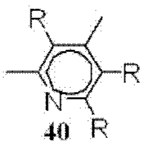 40

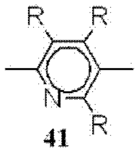 41

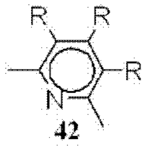 42

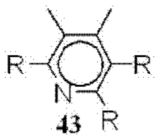 43

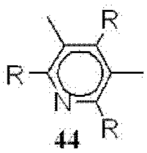 44

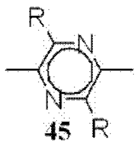 45

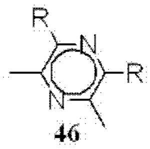 46

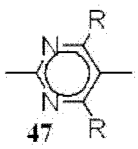 47

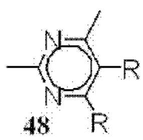 48

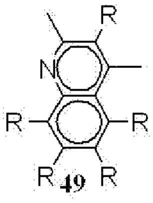 49

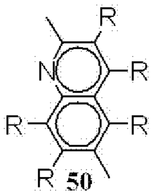 50

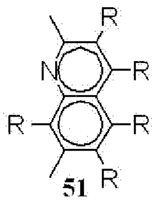 51

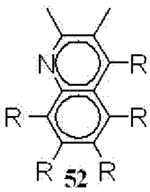 52

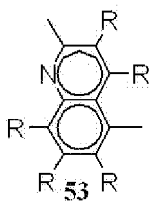 53

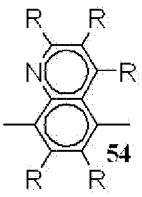 54

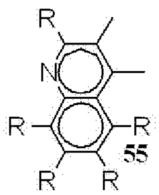 55

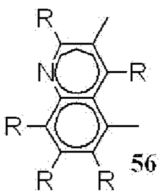 56

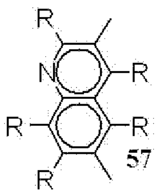 57

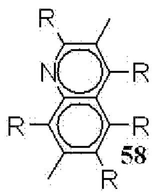 58

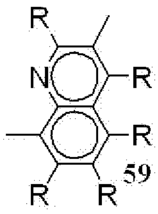 59

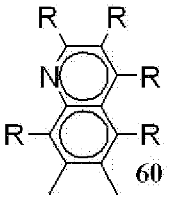 60

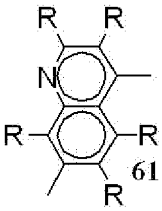 61

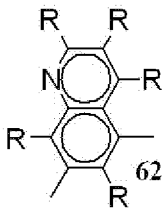 62

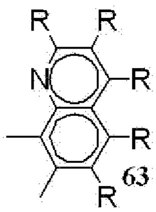 63

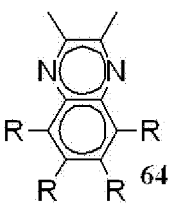 64

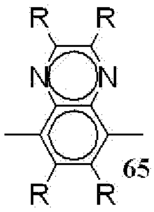 65

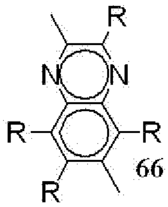 66

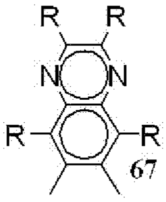 67

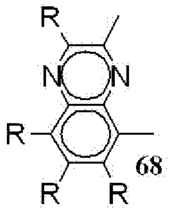 68

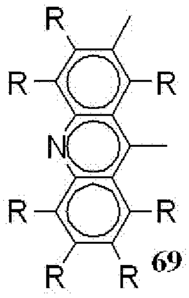 69

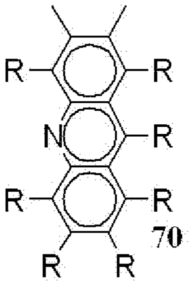 70

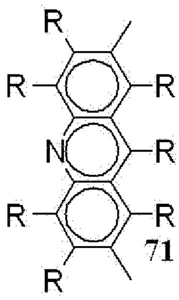 71

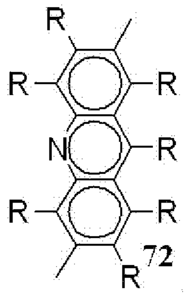 72

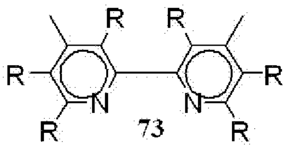 73

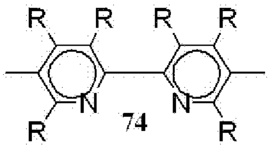 74

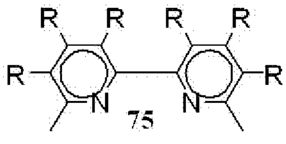 75

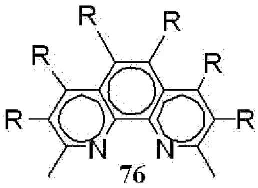 76

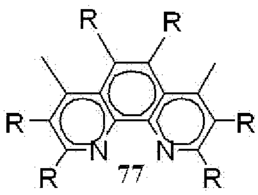 77

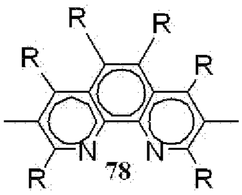 78

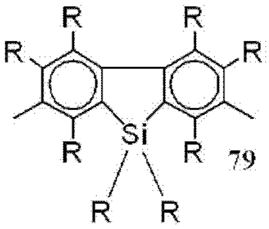 79

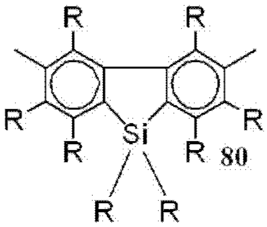 80

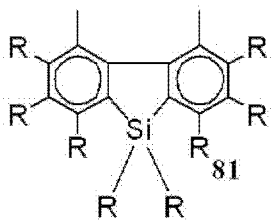 81

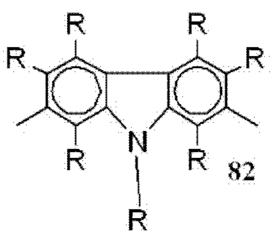 82

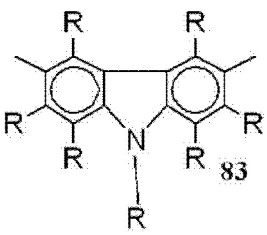 83

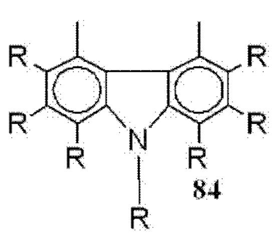 84

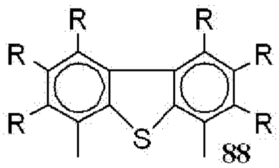 88

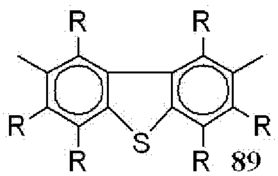 89

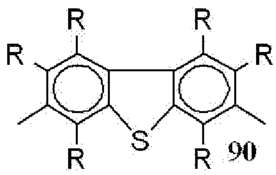 90

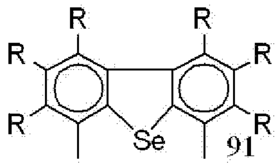
91

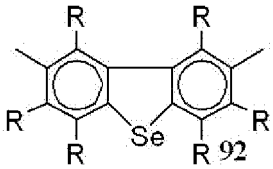
92

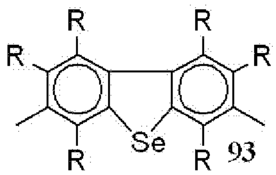
93

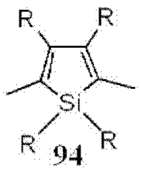
94

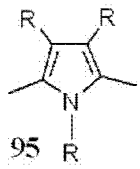
95

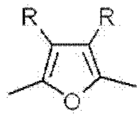
96

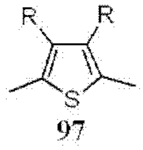
97

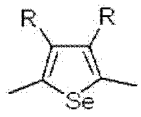
98

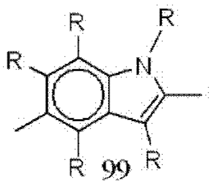
99

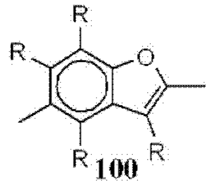
100

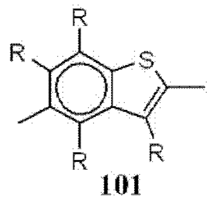
101

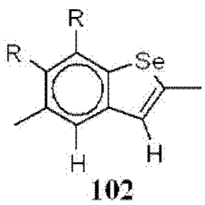
102

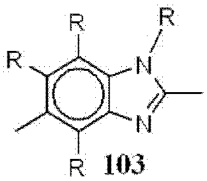
103

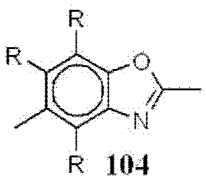
104

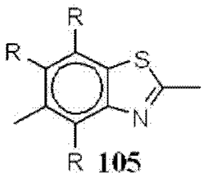
105

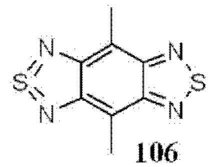
106

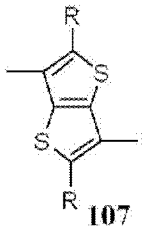
107

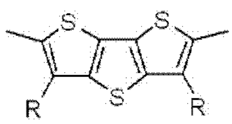
108

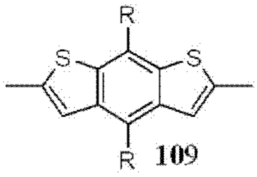
109

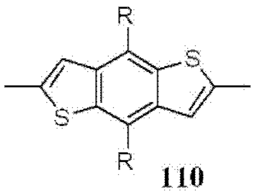
110

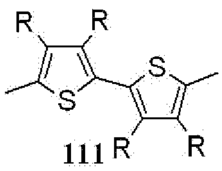
111

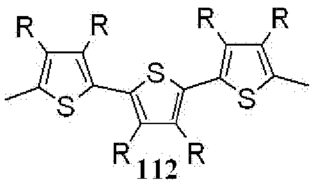
112

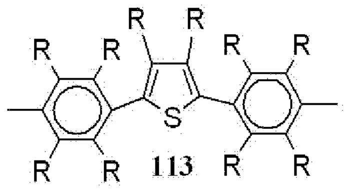
113

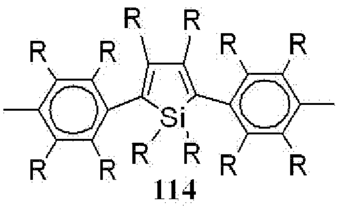
114

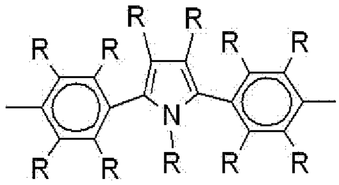
115

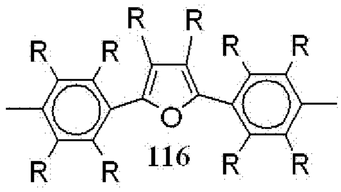
116

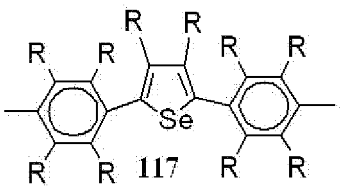
117

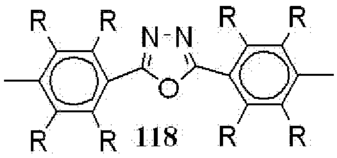
118

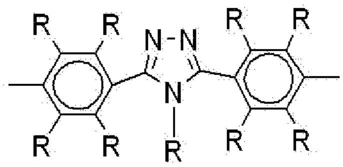
119

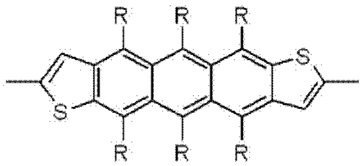
120

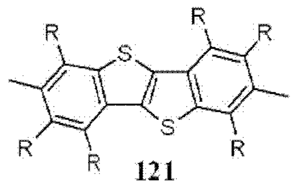
121

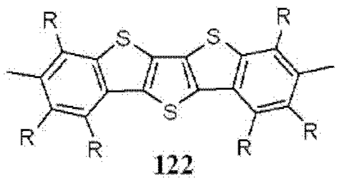
122

In the formulae 1 to 122, R represents the same meaning as described above.

It is preferable that $Ar^1$ is a constituent unit represented by any of the formulae (3-1) to (3-8), from the standpoint of enhancement of the short circuit current density of an organic photoelectric conversion device containing the polymer compound of the present invention.

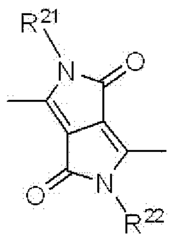
(3-1)

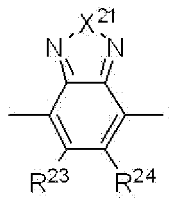
(3-2)

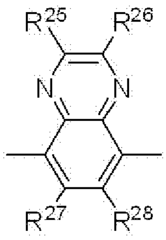
(3-3)

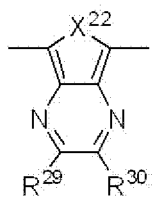
(3-4)

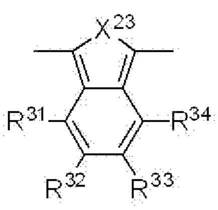
(3-5)

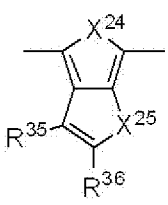
(3-6)

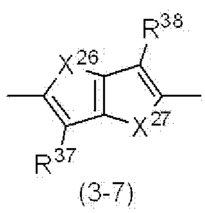
(3-7)

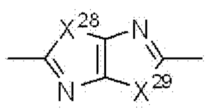
(3-8)

[In the formulae (3-1) to (3-8), $R^{21}$ to $R^{38}$ represent each independently a hydrogen atom or a substituent. $X^{21}$ to $X^{29}$ represent each independently a sulfur atom, an oxygen atom or a selenium atom.].

The definition and specific examples of the substituent represented by $R^{21}$ to $R^{38}$ are the same as the definition and specific examples of the substituent represented by $R^3$.

$R^{21}$, $R^{22}$ and $R^{35}$ are preferably an optionally substituted alkyl group, an optionally substituted alkoxy group and an optionally substituted alkylthio group, more preferably an optionally substituted alkyl group and an optionally substituted alkoxy group, particularly preferably an optionally substituted alkyl group. The alkyl group is preferably a branched alkyl group, from the standpoint of enhancement of the solubility of the polymer compound of the present invention.

$R^{23}$, $R^{24}$, $R^{27}$, $R^{28}$, $R^{31}$, $R^{32}$, $R^{33}$, $R^{34}$, $R^{37}$ and $R^{38}$ are preferably a halogen atom and a hydrogen atom, more preferably a fluorine atom and a hydrogen atom.

$R^{25}$, $R^{26}$, $R^{29}$ and $R^{30}$ are preferably a hydrogen atom, a halogen atom, an optionally substituted alkyl group, an optionally substituted aryl group and an optionally substituted arylalkyl group, more preferably a hydrogen atom and an optionally substituted arylalkyl group.

$R^{36}$ is preferably a hydrogen atom, a halogen atom, an acyl group and an acyloxy group, more preferably an acyl group and an acyloxy group.

In the formulae (3-1) to (3-8), $X^{21}$ to $X^{29}$ represent each independently a sulfur atom, an oxygen atom or a selenium atom. $X^{21}$ to $X^{29}$ are preferably a sulfur atom and an oxygen atom, more preferably a sulfur atom.

$Ar^1$ is more preferably a constituent unit represented by the formulae (3-1) to (3-6), particularly preferably a constituent unit represented by the formula (3-2). Specific examples of the constituent unit represented by the formula (3-2) include constituent units represented by the formulae (3-2-1) to (3-2-9).

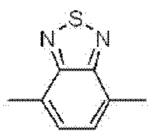
(3-2-1)

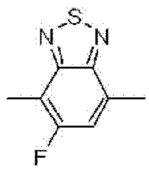
(3-2-2)

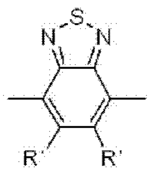
(3-2-3)

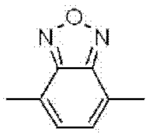
(3-2-4)

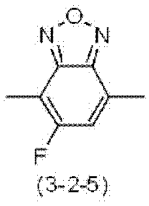
(3-2-5)

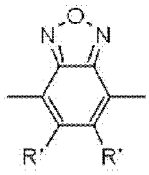
(3-2-6)

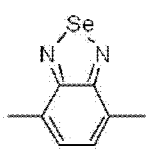
(3-2-7)

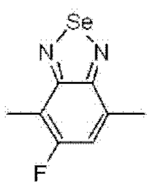
(3-2-8)

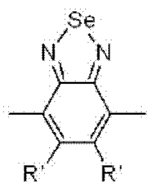
(3-2-9)

(In the formulae, R' represents a substituent.).

The definition and specific examples of the substituent represented by R' are the same as the definition and specific examples of the substituent represented by $R^3$.

When the polymer compound of the present invention is composed of a constituent unit represented by the formula (1) and a constituent unit represented by the formula (2), the number of constituent units represented by the formula (1) is preferably 20 to 80 and the number of constituent units represented by the formula (2) is preferably 20 to 80, if the total number of constituent units in the polymer compound of the present invention is assumed to be 100.

When the polymer compound of the present invention is composed of a constituent unit represented by the formula (1), a constituent unit represented by the formula (2) and a constituent unit represented by the formula (3), the number of constituent units represented by the formula (1) is preferably 20 to 50 if the total number of constituent units in the polymer compound of the present invention is assumed to be 100, the number of constituent units represented by the formula (2) is preferably 20 to 50 if the total number of constituent units in the polymer compound of the present invention is assumed to be 100, and the number of constituent units represented by the formula (3) is preferably 30 to 60 if the total number of constituent units in the polymer compound of the present invention is assumed to be 100.

As described above, the polymer compound of the present invention may contain any constituent unit in addition

to the constituent unit represented by the formula (1) and the constituent unit represented by the formula (2), and this constituent unit includes divalent organic groups. Of divalent organic groups, groups represented by the following formula (1000) are mentioned as suitable examples.

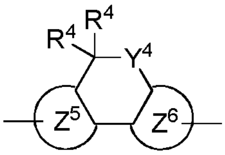

(1000)

In the formula (1000), $R^4$ represents a hydrogen atom or a substituent. $R^4$ is a group different from $R^1$, $R^2$. The definition and specific examples of the substituent represented by $R^4$ are the same as the definition and specific examples of the substituent represented by $R^3$.

$Y^4$ represents an oxygen atom, a sulfur atom or -N($R^3$)-. $R^3$ represents a hydrogen atom or a substituent. The definition and specific examples of the substituent represented by $R^3$ are the same as the definition and specific examples of the substituent represented by $R^3$.

Ring $Z^5$ and ring $Z^6$ represent each independently an optionally substituted aromatic carbocyclic ring or an optionally substituted heterocyclic ring. Specific examples of the aromatic carbocyclic ring and the heterocyclic ring represented by ring $Z^5$ and ring $Z^6$ are the same as specific examples of the aromatic carbocyclic ring and the heterocyclic ring represented by ring $Z^1$ and ring $Z^2$. The definition and specific examples of the substituent which the aromatic carbocyclic ring and the heterocyclic ring represented by ring $Z^5$ and ring $Z^6$ may optionally have are the same as the definition and specific examples of the substituent represented by $R^3$.

$R^4$ is preferably an optionally substituted alkyl group, an optionally substituted alkoxy group, an optionally substituted aryl group, an optionally substituted aryloxy group, further preferably an optionally substituted aryl group, an optionally substituted aryloxy group, further preferably an optionally substituted aryl group.

As the divalent organic group described above, for example, structures represented by the following formulae (1001) to (1020) are exemplified.

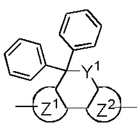

(1001)

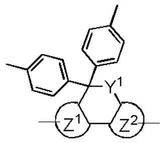

(1002)

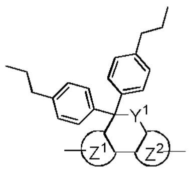

(1003)

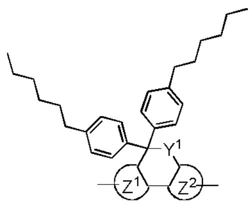

(1004)

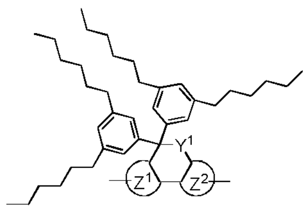

(1005)

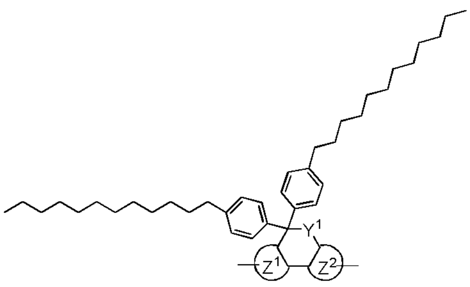

(1006)

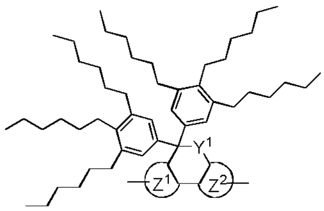

(1007)

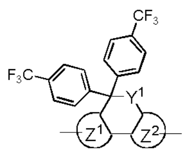

(1008)

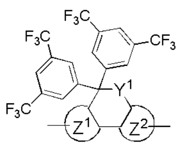

(1009)

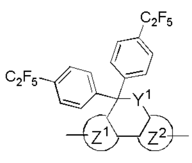

(1010)

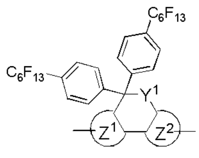

(1011)

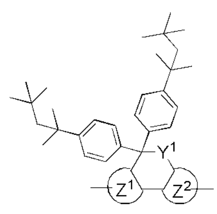

(1012)

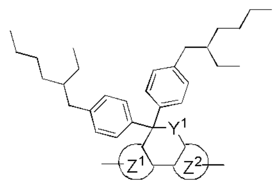

(1013)

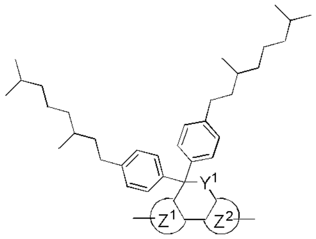

(1014)

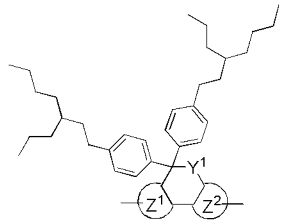

(1015)

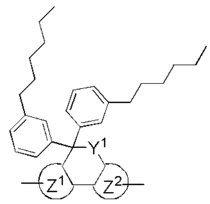

(1016)

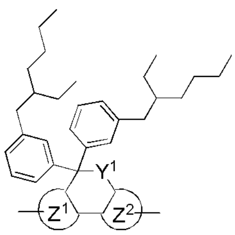

(1017)

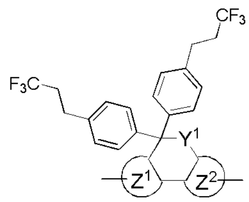

(1018)

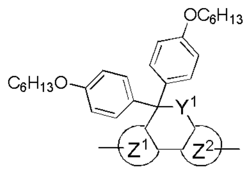

(1019)

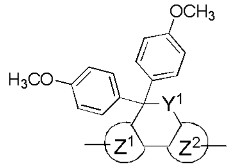

(1020)

Of the formulae (1001) to (1020), the formula (1001), the formula (1003), the formula (1004), the formula (1005) and the formula (1008) are preferable, the formula (1001), the formula (1003) and the formula (1008) are further preferable, the formula (1008) is particularly preferable.

When the polymer compound of the present invention contains a constituent unit represented by the formula (1000), the number of constituent units represented by the formula (1000) is preferably 20 to 80, the number of constituent units represented by the formula (1) is preferably 10 to 40 and the number of constituent units represented by the formula (2) is preferably 10 to 40, if the total number of constituent units represented by the formula (1), constituent units represented by the formula (2) and constituent units represented by the formula (1000) is assumed to be 100.

The polymer compound of the present invention is, in general, a compound having a weight-average molecular weight of 1000 or more. The weight-average molecular weight of the polymer compound in the present invention is preferably 3000 to 10000000, more preferably 8000 to 5000000, particularly preferably 10000 to 1000000. If the weight-average molecular weight is smaller than 3000, firm formability in device fabrication may be deficient, while if the weight-average molecular weight is larger than 10000000, solubility in a solvent and applicability in device fabrication may lower.

The weight-average molecular weight in the present invention denotes a polystyrene-equivalent weight-average molecular weight calculated by using a polystyrene standard sample in gel permeation chromatography (GPC).

When the polymer compound of the present invention is used in a device, it is desirable that the solubility of the polymer compound in a solvent is high from the standpoint of easiness of fabrication of the device. Specifically, it is preferable that the polymer compound of the present invention has solubility by which a solution containing the polymer compound in an amount of 0.01 wt% or more can be produced, it is more preferable that is has solubility by which a solution containing the polymer compound in an amount of 0.1 wt% or more can be produced, it is further preferable that it has solubility by which a solution containing the polymer compound in an amount of 0.4 wt% or more can be produced,

Thought the method of producing a polymer compound composed of a constituent unit represented by the formula (1), a constituent unit represented by the formula (2) and a constituent unit represented by the formula (3) and a polymer compound composed of a constituent unit represented by the formula (1), a constituent unit represented by the formula (2), a constituent unit represented by the formula (3) and a constituent unit represented by the formula (1000) is not particularly restricted, preferable are methods using the Suzuki coupling reaction and the Stille coupling reaction from the standpoint of easiness of synthesis of the polymer compound.

The method of using the Suzuki coupling reaction includes, for example, a production method having a step of reacting at least one compound represented by the formula (100):

$$Q^{100}-E^{1}-Q^{200} \quad (100)$$

(wherein $E^1$ represents a constituent unit represented by the formula (3). $Q^{100}$ and $Q^{200}$ represent each independently a dihydroxyboryl group ($-B(OH)_2$) or a borate residue.) and two or more compounds represented by the formula (200):

$$T^1-E^2-T^2 \quad (200)$$

(wherein $E^2$ represents a constituent unit represented by the formulae (1), a constituent unit represented by the formulae (2) or a constituent unit represented by the formulae (3). $T^1$ and $T^2$ represent each independently a halogen atom or a sulfonic residue.)
in the presence of a palladium catalyst and a base. $E^1$ is preferably a constituent unit represented by the formulae (3-1) to (3-8).

In this case, it is preferable that the total number of moles of two or more compounds represented by the formula (200) used in the reaction is excess over the total number of moles of at least one compound represented by the formula (100). When the total number of moles of two or more compounds represented by the formula (200) used in the reaction is 1 mol, the total number of moles of at least one compound represented by the formula (100) is preferably 0.6 to 0.99 mol, further preferably 0.7 to 0.95 mol.

The borate residue means a group obtained by removing a hydroxyl group from a boric acid diester, and includes a dialkyl ester residue, a diaryl ester residue, a di(arylalkyl)ester residue and the like. As specific examples of the borate residue, groups represented by the following formulae are exemplified.

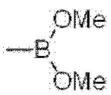 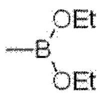 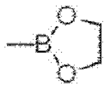 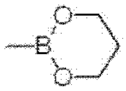 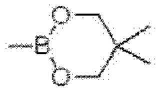 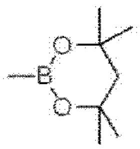 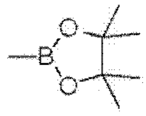 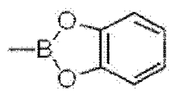

(wherein Me represents a methyl group and Et represents an ethyl group.).

The halogen atom represented by $T^1$ and $T^2$ in the formula (200) includes a fluorine atom, a chlorine atom, a bromine atom and an iodine atom. From the standpoint of easiness of synthesis of the polymer compound, a bromine atom and an iodine atom are preferable, a bromine atom is more preferable.

The sulfonic residue represented by $T^1$ and $T^2$ in the formula (200) denotes an atomic group obtained by removing an acidic hydrogen from sulfonic acid ($-SO_3H$), and specific examples thereof include alkyl sulfonate groups (for example, a methane sulfonate group, an ethane sulfonate group), aryl sulfonate groups (for example, a benzene sulfonate group, a p-toluene sulfonate group), arylalkyl sulfonate groups (for example, a benzyl sulfonate group) and a trifluoromethane sulfonate group.

The method of conducting the Suzuki coupling reaction includes, specifically, a method of reacting in the presence of a base using a palladium catalyst as the catalyst in any solvent.

The palladium catalyst used in the Suzuki coupling reaction includes, for example, Pd(0) catalysts and Pd(II) catalysts, specifically palladium[tetrakis(triphenylphosphine)], palladium acetates, dichlorobis(triphenylphosphine)palladium, palladium acetate, tris(dibenzylideneacetone)dipalladium and bis(dibenzylideneacetone)palladium, and from the standpoint of easiness of the reaction (polymerization) operation and the reaction (polymerization) speed, preferable are dichlorobis(triphenylphosphine)palladium, palladium acetate and tris(dibenzylideneacetone)dipalladium.

The addition amount of the palladium catalyst is not particularly restricted, and amounts effective as the catalyst are permissible, however, the amount with respect to 1 mol of a compound represented by the formula (100) is usually 0.0001 mol to 0.5 mol, preferably 0.0003 mol to 0.1 mol.

When palladium acetates are used as the palladium catalyst to be used in the Suzuki coupling reaction, phosphorus compounds such as triphenylphosphine, tri(o-tolyl)phosphine, tri(o-methoxyphenyl)phosphine and the like can be added as a ligand. In this case, the addition amount of a ligand is usually 0.5 mol to 100 mol, preferably 0.9 mol to 20 mol, further preferably 1 mol to 10 mol with respect to 1 mol of the palladium catalyst.

The base to be used in the Suzuki coupling reaction includes inorganic bases, organic bases, inorganic salts and the like. The inorganic base includes, for example, potassium carbonate, sodium carbonate and barium hydroxide. The organic base includes, for example, triethylamine and tributylamine. The inorganic salt includes, for example, cesium fluoride.

The addition amount of the base is usually 0.5 mol to 100 mol, preferably 0.9 mol to 20 mol, further preferably 1 mol to 10 mol with respect to 1 mol of a compound represented by the formula (100).

The Suzuki coupling reaction is usually carried out in a solvent. As the solvent, exemplified are N,N-dimethylformamide, toluene, dimethoxyethane and tetrahydrofuran. From the standpoint of solubility of the polymer compound used in the present invention, toluene and tetrahydrofuran are preferable. It may be permissible that an aqueous solution of a base is added, and the reaction is performed in a two-phase system. When an inorganic salt is used as the base, it is usual that an aqueous solution of a base is added and the reaction is performed, from the standpoint of solubility of

the inorganic salt.

When an aqueous solution of a base is added and the reaction is performed in a two-phase system, a phase transfer catalyst such as quaternary ammonium salts and the like may be added, if required.

The temperature for conducting the Suzuki coupling reaction is usually 50 to 160°C, depending on the above-described solvent, and the temperature is preferably 60 to 120°C, from the standpoint of increasing the molecular weight of the polymer compound. It may also be permissible that the temperature is raised up close to the boiling point of a solvent and reflux is performed. Though the time when the intended degree of polymerization is attained is defined as the end point, the reaction time is usually 0.1 hour to 200 hours. The reaction times around 1 hour to 30 hours are efficient and preferable.

The Suzuki coupling reaction is conducted in a reaction system not deactivating a Pd(0) catalyst, under an inert atmosphere such as an argon gas, a nitrogen gas and the like. It is conducted, for example, in a system sufficiently deaerated with an argon gas, a nitrogen gas and the like. Specifically, an atmosphere in a polymerization vessel (reaction system) is deaerated by sufficiently purging with a nitrogen gas, then, a compound represented by the formula (100), a compound represented by the formula (200) and dichlorobis(triphenylphosphine)palladium(II) are charged into this polymerization vessel, further, an atmosphere in the polymerization vessel is deaerated by sufficiently purging with a nitrogen gas, then, a solvent deaerated by previously bubbling with a nitrogen gas, for example, toluene, is added, then, a base deaerated by previously bubbling with a nitrogen gas, for example, a sodium carbonate aqueous solution is dropped into this solution, then, the solution is heated and the temperature is raised, for example, up to the reflux temperature, and polymerization is carried out at this temperature for 8 hours while keeping an inert atmosphere.

The method of using the Stille coupling reaction includes, for example, a production method having a step of reacting at least one compound represented by the formula (300):

$$Q^{300}-E^{3}-Q^{400} \qquad (300)$$

(wherein $E^3$ represents a constituent unit represented by the formula (3). $Q^{300}$ and $Q^{400}$ represent each independently a substituted stannyl group.).

and two or more compounds represented by the formula (200) described above in the presence of a palladium catalyst. $E^3$ is preferably a constituent unit represented by the formulae (3-1) to (3-8).

The substituted stannyl group includes a group represented by $-SnR^{100}{}_3$, and the like. Here, $R^{100}$ represents a mono-valent organic group. The mono-valent organic group includes an alkyl group, an aryl group and the like.

The alkyl group has a number of carbon atom s of usually 1 to 30, and specific examples thereof include linear alkyl groups such as a methyl group, an ethyl group, a propyl group, an isopropyl group, a butyl group, an isobutyl group, a sec-butyl group, a tert-butyl group, a pentyl group, an isopentyl group, a 2-methylbutyl group, a 1-methylbutyl group, a hexyl group, an isohexyl group, a 3-methylpentyl group, a 2-methylpentyl group, a 1-methylpentyl group, a heptyl group, an octyl group, an isooctyl group, a 2-ethylhexyl group, a nonyl group, a decyl group, an undecyl group, a dodecyl group, a tetradecyl group, a hexadecyl group, an octadecyl group, an eicosyl group and the like, and cycloalkyl groups such as a cyclopentyl group, a cyclohexyl group, an adamantyl group and the like. The aryl group includes a phenyl group, a naphthyl group and the like. The substituted stannyl group includes preferably $-SnMe_3$, $-SnEt_3$, $-SnBu_3$ and $SnPh_3$, further preferably $-SnMe_3$, $-SnEt_3$ and $SnBu_3$. In the above-described preferable examples, Me represents a methyl group, Et represents an ethyl group, Bu represents a butyl group and Ph represents a phenyl group.

The halogen atom represented by $T^1$ and $T^2$ in the formula (200) includes a fluorine atom, a chlorine atom, a bromine atom and an iodine atom. From the standpoint of easiness of synthesis of the polymer compound, a bromine atom and an iodine atom are preferable.

As the alkyl sulfonate group represented by $T^1$ and $T^2$ in the formula (200), a methane sulfonate group, an ethane sulfonate group and a trifluoromethane sulfonate group are exemplified. As the aryl sulfonate group, a benzene sulfonate group and a p-toluene sulfonate group are exemplified. As the aryl sulfonate group, a benzyl sulfonate group is exemplified.

Specific examples thereof include a method of reacting in any solvent in the presence of, for example, a palladium catalyst as the catalyst.

The palladium catalyst used in the Stille coupling reaction includes, for example, Pd(0) catalysts and Pd(II) catalysts. Specifically, palladium[tetrakis(triphenylphosphine)], palladium acetates, dichlorobis(triphenylphosphine)palladium, palladium acetate, tris(dibenzylideneacetone)dipalladium and bis(dibenzylideneacetone)palladium are mentioned, and from the standpoint of easiness of the reaction (polymerization) operation and the reaction (polymerization) speed, preferable are palladium[tetrakis(triphenylphosphine)] and tris(dibenzylideneacetone)dipalladium.

The addition amount of the palladium catalyst used in the Stille coupling reaction is not particularly restricted, and amounts effective as the catalyst are permissible, however, the amount with respect to 1 mol of a compound

represented by the formula (100) is usually 0.0001 mol to 0.5 mol, preferably 0.0003 mol to 0.2 mol.

In the Stille coupling reaction, a ligand and a co-catalyst can also be used, if necessary. The ligand includes, for example, phosphorus compounds such as triphenylphosphine, tri(o-tolyl)phosphine, tri(o-methoxyphenyl)phosphine, tris (2-furyl) phosphine and the like, and arsenic compounds such as triphenylarsine, triphenoxyarsine and the like. The co-catalyst includes copper iodide, copper bromide, copper chloride, copper(I) 2-thenoate and the like.

In the case of use of a ligand or a co-catalyst, the addition amount of a ligand or a co-catalyst is usually 0.5 mol to 100 mol, preferably 0.9 mol to 20 mol, further preferably 1 mol to 10 mol with respect to 1 mol of a palladium catalyst.

The Stille coupling reaction is usually conducted in a solvent. The solvent includes N,N-dimethylformamide, N, N-dimethylacetamide, toluene, dimethoxyethane, tetrahydrofuran and the like. From the standpoint of solubility of the polymer compound used in the present invention, toluene and tetrahydrofuran are preferable.

The temperature for conducting the Stille coupling reaction is usually 50 to 160°C, depending on the solvent described above, however, from the standpoint of increasing the molecular weight of the polymer compound, it is preferably 60 to 120°C. It may also be permissible that the temperature is raised up close to the boiling point of a solvent and reflux is performed.

Though the time when the intended degree of polymerization is attained is defined as the end point, the time for effecting the above-described reaction (reaction time) is usually about 0.1 hour to 200 hours. The reaction times around 1 hour to 30 hours are efficient and preferable.

The Stille coupling reaction is conducted in a reaction system not deactivating a Pd catalyst, under an inert atmosphere such as an argon gas, a nitrogen gas and the like. It is conducted, for example, in a system sufficiently deaerated with an argon gas, a nitrogen gas and the like. Specifically, an atmosphere in a polymerization vessel (reaction system) is deaerated by sufficiently purging with a nitrogen gas, then, a compound represented by the formula (300), a compound represented by the formula (200) and a palladium catalyst are charged into this polymerization vessel, further, an atmosphere in the polymerization vessel is deaerated by sufficiently purging with a nitrogen gas, then, a solvent deaerated by previously bubbling with a nitrogen gas, for example, toluene, is added, then, if necessary, a ligand and a co-catalyst are added, and thereafter, the solution is heated and the temperature is raised, for example, up to the reflux temperature, and polymerization is carried out at this temperature for 8 hours while keeping an inert atmosphere.

The polystyrene-equivalent number-average molecular weight of the polymer compound of the present invention is preferably $1\times10^3$ to $1\times10^8$. When the polystyrene-equivalent number-average molecular weight is $1\times10^3$ or more, a tough film is obtained easily. While, when $10^8$ or lower, solubility is high and fabrication of a film is easy.

The polystyrene-equivalent number-average molecular weight of the polymer compound of the present invention is preferably 3000 or more.

If a polymerization active group remains intact at the end of the polymer compound of the present invention, there is a possibility of lowering of the life and the property of a device obtained when the compound is used for fabrication of the device, therefore, it may be protected with a stable group. Those having a conjugated bond consecutive to the conjugated structure of the main chain are preferable, and for example, structures having a linkage to an aryl group or a heterocyclic group via a vinylene group may also be used.

A monomer as a raw material of the polymer compound of the present invention can be synthesized, for example, according to a description of WO2011/052709.

The compound of the present invention is preferably a compound having a light absorption terminal wavelength of 700 nm or more, more preferably a compound having a light absorption terminal wavelength of 800 nm or more, particularly preferably a compound having a light absorption terminal wavelength of 900 nm or more, from the standpoint of enhancement of the photoelectric conversion efficiency of an organic photoelectric conversion device containing the compound of the present invention.

The light absorption terminal wavelengthin the present invention means a value determined by the following method.

For measurement, use is made of a spectrophotometer functioning in a region of the wavelength of ultraviolet, visible and near-infrared (for example, ultraviolet visible near-infrared spectrophotometer JASCO-V670, manufactured by JASCO Corporation). Since the measurable wavelength range is from 200 to 1500 nm in the case of use of JASCO-V670, measurement is performed in this wavelength range. First, the absorption spectrum of a substrate used for measurement is measured. As the substrate, use is made of a quartz substrate, a glass substrate and the like. Then, on the substrate, a film containing the compound of the present invention is formed from a solution containing the compound of the present invention or a molten material containing the compound of the present invention. In film formation from a solution, drying is performed after the film formation. Thereafter, the absorption spectrum of a laminate of the film and the substrate is measured. The difference between the absorption spectrum of a laminate of the film and the substrate and the absorption spectrum of the substrate is regarded as the absorption spectrum of the film.

In the absorption spectrum of the film, the ordinate axis represents the absorbance of the compound of the present invention and the abscissa axis represents wavelength. It is desirable to adjust the thickness of a film so that the highest absorbance among the absorption peaks may be between about 0.5 and 2. When the absorbance of the

absorption peak longest in wavelength among the absorption peaks taken as 100%, an intersection of that absorption peak and the straight line that is parallel to the wavelength axis and includes a point of the 50% absorbance is defined as a first point, where the intersection has a wavelength longer than the peak wavelength of that absorption peak. An intersection of that absorption peak and the straight line that is parallel to the wavelength axis and includes a point of the 25% absorbance is defined as a second point, where the intersection has a wavelength longer than the peak wavelength of that absorption peak. The intersection of a baseline and a straight line extending through the first point and the second point is defined as a light absorption terminal wavelength. The baseline referred to above represents a straight line extending through a third point and a fourth point thereon, the third point being a point on the absorption spectrum located at a wavelength 100 nm longer than the base wavelength and the fourth point being a point on the absorption spectrum at a wavelength 150 nm longer than the base wavelength, where the base wavelength denotes, when the absorbance of the absorption peak longest in wavelength taken as 100%, the wavelength of such a point at which that absorption peak intersects with the straight line parallel to the wavelength axis and including a point of the 10% absorbance and that has a wavelength longer than the peak wavelength of that absorption peak.

Since the compound of the present invention can manifest high electron and/or hole transportability, when an organic film containing the polymer compound is used in a device, electrons and holes injected from an electrode or charges generated by light absorption can be transported. By utilizing such properties, the polymer compound can be suitably used in various electronic devices such as a photoelectric conversion device, an organic film transistor, an organic electroluminescent device and the like. These devices will be illustrated individually below.

A photoelectric conversion device containing the polymer compound of the present invention has at least one active layer containing the polymer compound of the present invention between a pair of electrodes.

A preferable embodiment of the photoelectric conversion device containing the polymer compound of the present invention has a pair of electrodes at least one of which is transparent or semi-transparent, and an active layer formed of an organic composition composed of a p-type organic semiconductor and an n-type organic semiconductor. The polymer compound of the present invention is preferably used as a p-type organic semiconductor.

The photoelectric conversion device produced by using the polymer compound of the present invention is usually formed on a substrate. This substrate may advantageously be one which does not chemically change in forming an electrode and in forming a layer of an organic material. The material of the substrate includes, for example, glass, plastic, polymer film and silicon. In the case of an opaque substrate, it is preferable that the opposite electrode, namely, an electrode which is more remote from the substrate is transparent or semi-transparent.

Another embodiment of the photoelectric conversion device containing the polymer compound of the present invention is a photoelectric conversion device containing a first active layer containing the compound of the present invention, and a second active layer containing an electron accepting compound such as fullerene derivatives and the like adjacent to the first active layer, between a pair of electrodes at least one of which is transparent or semi-transparent.

The transparent or semi-transparent electrode material includes electrically conductive metal oxide films, semi-transparent metal films and the like. Specifically, use is made of films fabricated using an electrically conductive material composed of indium oxide, zinc oxide, tin oxide, and a composite thereof: indium·tin·oxide (ITO), indium·zinc·oxide and the like; films of NESA, gold, platinum, silver and copper, and preferable are films of ITO, indium·zinc·oxide and tin oxide. The electrode fabrication method includes a vacuum vapor deposition method, a sputtering method, an ion plating method, a plating method and the like.

As the electrode material, transparent electrically conductive films of organic materials such as polyaniline and derivatives thereof, polythiophene and derivatives thereof and the like may be used.

One electrode may not be transparent, and as the material of this electrode, metals, electrically conductive polymers and the like can be used. Specific examples of the electrode material include metals such as lithium, sodium, potassium, rubidium, cesium, magnesium, calcium, strontium, barium, aluminum, scandium, vanadium, zinc, yttrium, indium, cerium, samarium, europium, terbium, ytterbium and the like, and alloys composed of two or more of them and alloys composed of at least one of the above-described metals and at least one metal selected from the group consisting of gold, silver, platinum, copper, manganese, titanium, cobalt, nickel, tungsten and tin; graphite, graphite intercalation compounds, polyaniline and derivatives thereof, polythiophene and derivatives thereof. The alloy includes a magnesium-silver alloy, a magnesium-indium alloy, a magnesium-aluminum alloy, an indium-silver alloy, a lithium-aluminum alloy, a lithium-magnesium alloy, a lithium-indium alloy and a calcium-aluminum alloy.

As the means for improving photoelectric conversion efficiency, an additional intermediate layer other than the active layer may be used. The material used as the intermediate layer includes, for example, halides of alkali metals such as lithium fluoride, halides of alkaline earth metals, oxides such as titanium oxide and the like; PEDOT (poly-3,4-ethylenedioxythiophene) and the like.

The active layer may contain the polymer compound of the present invention singly or may contain two or more of the polymer compounds of the present invention in combination. For enhancing hole transportability of the active layer, a compound other than the polymer compound of the present invention may be mixed in the active layer, as an electron donating compound and/or an electron accepting compound. The electron donating compound and the electron

accepting compound are relatively determined based on the energy level of these compounds.

The electron donating compound includes, for example, pyrazoline derivatives, arylamine derivatives, stilbene derivatives, triphenyldiamine derivatives, oligothiophene and derivatives thereof, polyvinylcarbazole and derivatives thereof, polysilane and derivatives thereof, polysiloxane derivatives having an aromatic amine residue in the main chain or side chain, polyaniline and derivatives thereof, polythiophene and derivatives thereof, polypyrrole and derivatives thereof, polyphenylenevinylene and derivatives thereof, polythienylenevinylene and derivatives thereof, in addition to the compound of the present invention.

The electron accepting compound includes, for example, carbon materials, metal oxides such as titanium oxide and the like, oxadiazole derivatives, anthraquinodimethane and derivatives thereof, benzoquinone and derivatives thereof, naphthoquinone and derivatives thereof, anthraquinone and derivatives thereof, tetracyanoanthraquinodimethane and derivatives thereof, fluorenone derivatives, diphenyldicyanoethylene and derivatives thereof, diphenoquinone derivatives, metal complexes of 8-hydroxyquinoline and derivatives thereof, polyquinoline and derivatives thereof, polyquinoxaline and derivatives thereof, polyfluorene and derivatives thereof, phenanthroline derivatives such as 2,9-dimethyl-4,7-diphenyl-1,10-phenanthroline (basocuproine) and the like, fullerene and fullerene derivatives, in addition to the polymer compound of the present invention, and preferable are titanium oxide, carbon nano tubes, fullerene and fullerene derivatives, particularly preferable are fullerene and fullerene derivative.

The fullerene and fullerene derivatives include $C_{60}$, $C_{70}$, $C_{76}$, $C_{78}$, $C_{84}$ and derivatives thereof. The fullerene derivative means a compound obtained by at least partially modifying fullerene.

The fullerene derivative includes, for example, a compound represented by the formula (6), a compound represented the formula (7), a compound represented the formula (8) and a compound represented the formula (9).

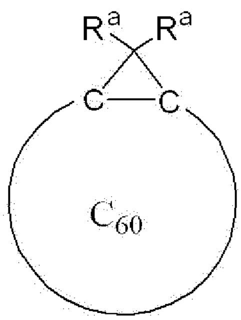
(6)

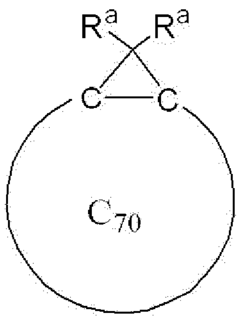
(7)

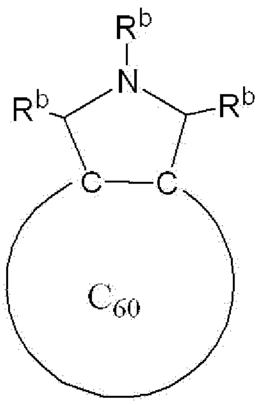
(8)

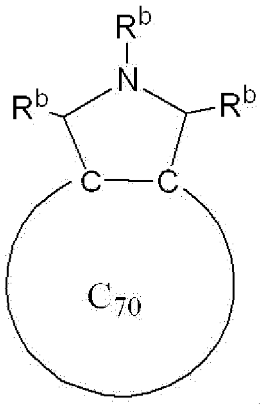
(9)

(in the formulae (6) to (9), $R^a$ represents an optionally substituted alkyl group, an optionally substituted aryl group, a heterocyclic group or a group having an ester structure. A plurality of $R^a$ may be the same or mutually different. $R^b$ represents an optionally substituted alkyl group or an optionally substituted aryl group. A plurality of $R^b$ may be the same or mutually different.)

The definition and specific examples of the optionally substituted alkyl group, the optionally substituted aryl group and the heterocyclic group represented by $R^a$ and $R^b$ are the same as the definition and specific examples of the optionally substituted alkyl group, the optionally substituted aryl group and the heterocyclic group represented by $R^3$.

The group having an ester structure represented by $R^a$ includes, for example, a group represented by the formula (10) .

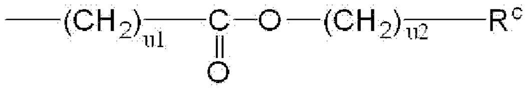
(10)

(wherein u1 represents an integer of 1 to 6, u2 represents an integer of 0 to 6, and $R^c$ represents an optionally substituted alkyl group, an optionally substituted aryl group or a heterocyclic group.)

The definition and specific examples of the optionally substituted alkyl group, the optionally substituted aryl group and the heterocyclic group represented by $R^c$ are the same as the definition and specific examples of the optionally substituted alkyl group, the optionally substituted aryl group and the heterocyclic group represented by $R^a$.

Specific examples of the $C_{60}$ fullerene derivatives include the following compounds.

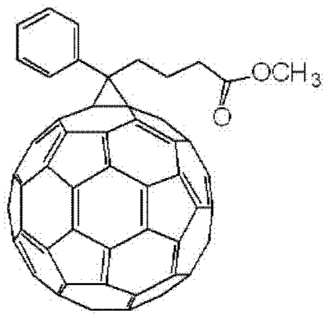
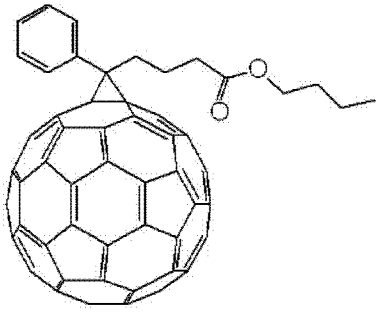
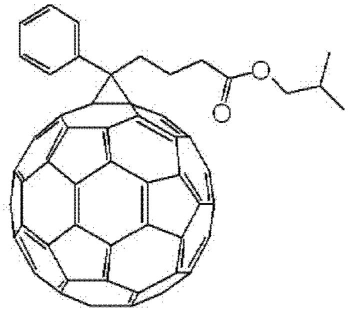

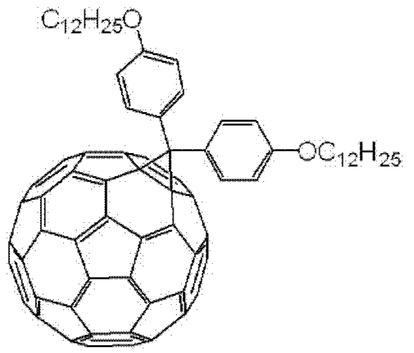
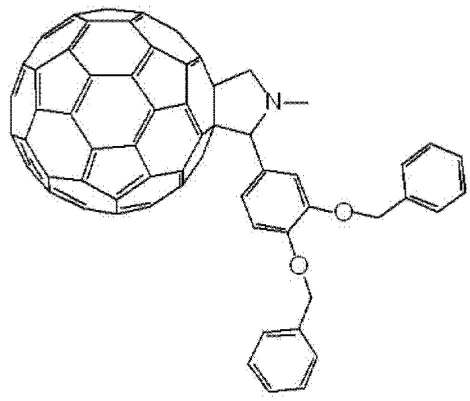

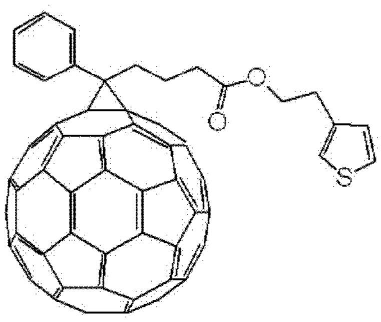
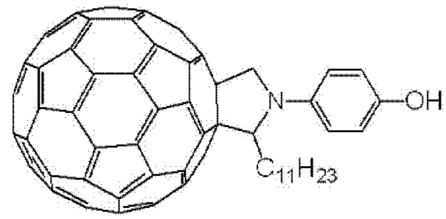

Specific examples of the $C_{70}$ fullerene derivatives include the following compounds.

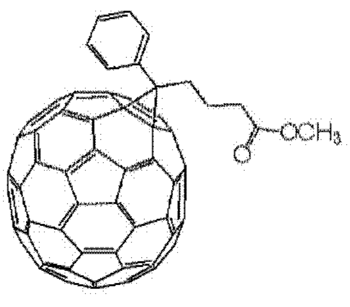
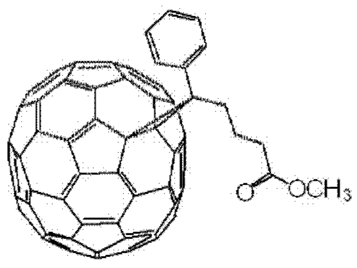
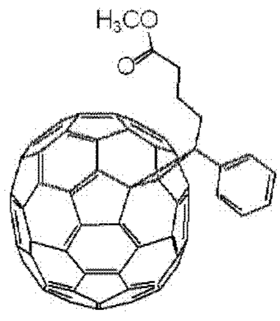

Examples of the fullerene derivatives include [6,6]-phenyl-C61 butyric acid methyl ester (C60PCBM, [6,6]-Phenyl C61 butyric acid methyl ester), [6,6]-phenyl-C71 butyric acid methyl ester (C70PCBM, [6,6]-Phenyl C71 butyric acid methyl ester), [6,6]-phenyl-C85 butyric acid methyl ester (C84PCBM, [6,6]-Phenyl C85 butyric acid methyl ester) and [6,6]-thienyl-C61 butyric acid methyl ester ([6,6]-Thienyl C61 butyric acid methyl ester).

It is preferable that the active layer of the organic photoelectric conversion device of the present invention contains a composition containing the compound of the present invention and electron accepting compound. The electron accepting compound is preferably a fullerene derivative.

When the active layer contains the polymer compound of the present invention and a fullerene derivative, the

amount of the fullerene derivative is preferably 10 to 1000 parts by weight, more preferably 20 to 500 parts by weight, with respect to 100 parts by weight of the compound of the present invention.

The active layer is preferably a film composed of the polymer compound of the present invention or a film composed of the polymer compound of the present invention and an electron accepting compound.

The thickness of the active layer is usually preferably 1 nm to 100 μm, more preferably 2 nm to 1000 nm, further preferably 5 nm to 500 nm, more preferably 20 nm to 200 nm.

The active layer may be produced by any method and the production method thereof includes, for example, methods of film formation from a solution containing a polymer compound and methods of film formation by vacuum vapor deposition.

A preferable method of producing an organic photoelectric conversion device is a production method of a device having a first electrode and a second electrode and an active layer between the first electrode and the second electrode, comprising a step of coating a solution (ink) containing the compound of the present invention and a solvent by a coating method to form the active layer on the first electrode and a step of forming the second electrode on the active layer. An active layer may be formed by using a solution containing the polymer compound of the present invention, an electron accepting compound and a solvent, instead of a solution containing the polymer compound of the present invention and a solvent.

The solvent used for film formation from a solution may advantageously be one which dissolves the compound of the present invention. The solvent includes, for example, hydrocarbon solvents such as toluene, xylene, mesitylene, tetralin, decalin, bicyclohexyl, butylbenzene, sec-butylbenzene, tert-butylbenzene and the like, halogenated hydrocarbon solvents such as carbon tetrachloride, chloroform, dichloromethane, dichloroethane, chlorobutane, bromobutane, chloropentane, bromopentane, chlorohexane, bromohexane, chlorocyclohexane, bromocyclohexane, chlorobenzene, dichlorobenzene, trichlorobenzene and the like, and ether solvents such as tetrahydrofuran, tetrahydropyran and the like. The polymer compound of the present invention can be usually dissolved in an amount of 0.1% by weight in the above-described solvent.

In the case of film formation using a solution, coating methods can be used such as a slit coat method, a knife coat method, a spin coat method, a casting method, a micro gravure coat method, a gravure coat method, a bar coat method, a roll coat method, a wire bar coat method, a dip coat method, a spray coat method, a screen printing method, a gravure printing method, a flexo printing method, an offset printing method, an inkjet coat method, a dispenser printing method, a nozzle coat method, a capillary coat method and the like, and preferable are a slit coat method, a capillary coat method, a gravure coat method, a micro gravure coat method, a bar coat method, a knife coat method, a nozzle coat method, an inkjet coat method and a spin coat method.

From the standpoint of film formability, the surface tension of a solvent at 25°C is preferably larger than 15 mN/m, more preferably larger than 15 mN/m and smaller than 100 mN/m, further preferably larger than 25 mN/m and smaller than 60 mN/m.

The compound of the present invention can be used also in an organic film transistor. The organic film transistor includes those having a source electrode and a drain electrode, an organic semiconductor layer (active layer) acting as a current pathway between these electrodes, and a gate electrode controlling the amount of current passing through this current pathway, wherein the organic semiconductor layer is constituted of the above-described organic film. Such an organic film transistor includes electric field effect types, electrostatic induction types and the like.

It is preferable that the electric field effect type organic film transistor has a source electrode and a drain electrode, an organic semiconductor layer (active layer) acting as a current pathway between them, a gate electrode controlling the amount of current passing through this current pathway, and an insulation layer disposed between the organic semiconductor layer and the gate electrode. Particularly, it is preferable that the source electrode and the drain electrode are disposed in contact with the organic semiconductor layer (active layer), and further, the gate electrode is disposed sandwiching the insulation layer in contact with the organic semiconductor layer. In the electric field effect type organic film transistor, the organic semiconductor layer is constituted of an organic film containing the polymer compound of the present invention.

It is preferable that the electrostatic induction type organic film transistor has a source electrode and a drain electrode, an organic semiconductor layer (active layer) acting as a current pathway between them, and a gate electrode controlling the amount of current passing through this current pathway, and this gate electrode is provided in an organic semiconductor layer. Particularly, it is preferable that the source electrode, the drain electrode and the gate electrode provided in the organic semiconductor layer are disposed in contact with the organic semiconductor layer. Here, the structure of the gate electrode may be a structure in which a current pathway flowing from the source electrode to the drain electrode is formed and the amount of current flowing in the current pathway can be controlled by voltage applied to the gate electrode, and for example, a comb-shaped electrode is mentioned. Also in the electrostatic induction type organic film transistor, the organic semiconductor layer is constituted of an organic film containing the compound of the present invention.

The compound of the present invention can also be used in an organic electroluminescent device (organic EL

device). The organic EL device has a light emitting layer between a pair of electrodes at least one of which is transparent or semi-transparent. The organic EL device may also contain a hole transporting layer and an electron transporting layer, in addition to the light emitting layer. The compound of the present invention is contained in any of the light emitting layer, the hole transporting layer and the electron transporting layer. The light emitting layer may also contain a charge transporting material (meaning a genetic name of an electron transporting material and a hole transporting material), in addition to the compound of the present invention. The organic EL device includes a device having an anode, a light emitting layer and a cathode; a device having an anode, a light emitting layer, an electron transporting layer and a cathode, further having an electron transporting layer containing an electron transporting material between the cathode and the light emitting layer in adjacent to the light emitting layer; a device having an anode, a hole transporting layer, a light emitting layer and a cathode, further having a hole transporting layer containing a hole transporting material between the anode and the light emitting layer in adjacent to the light emitting layer; a device having an anode, a hole transporting layer, a light emitting layer, an electron transporting layer and a cathode; and the like.

The organic photoelectric conversion device using the compound of the present invention is irradiated with a light such as sunlight or the like through a transparent or semi-transparent electrode, thereby generating photovoltaic power between electrodes, thus, it can be operated as an organic film solar battery. A plurality of organic film solar batteries can also be integrated and used as an organic film solar battery module.

By irradiating with a light through a transparent or semi-transparent electrode under condition of application of voltage between electrodes or under condition of no application, photocurrent flows, thus, it can be operated as an organic optical sensor. A plurality of organic optical sensors can also be integrated and used as an organic image sensor.

The above-described organic film transistor can be used, for example, as a picture element driving device used for regulating picture element control, screen luminance uniformity and screen rewriting speed of an electrophoresis display, a liquid crystal display, an organic electroluminescent display and the like.

The organic film solar battery can have a module structure which is basically the same as that of a conventional solar battery module. A solar battery module has generally a structure in which a cell is constituted on a supporting substrate such as a metal, ceramic and the like, the upper side thereof is covered with a filling resin, protective glass and the like and a light is introduced from the opposite side of the supporting substrate, however, it is also possible to provide a structure in which a transparent material such as reinforced glass and the like is used for the supporting substrate, a cell is constituted thereon and a light is introduced from the supporting substrate side. Specifically, module structures called super straight type, sub straight type or potting type, substrate-integrated module structures used in amorphous silicon solar batteries, and the like, are known. For the organic film solar battery produced by using the compound of the present invention, these module structures can be appropriately selected depending on the use object, the use place and environments.

A typical module of super straight type or sub straight type has a structure in which cells are disposed at regular interval between supporting substrates of which one side or both sides are transparent and on which a reflection preventing treatment has been performed, adjacent cells are mutually connected by a metal lead or flexible wiring and the like, a power collecting electrode is placed on an outer edge part and generated powder is harvested outside. Between the substrate and the cell, various kinds of plastic materials such as ethylene vinyl acetate (EVA) and the like may be used in the form of a film or filling resin depending on the object, for protection of the cell and for improvement in power collecting efficiency. In the case of use at places requiring no covering of the surface with a hard material such as a place receiving little impact from outside, it is possible that the surface protective layer is constituted of a transparent plastic film, or the above-described filling resin is hardened to impart a protective function, and one supporting substrate is omitted. The circumference of the supporting substrate is fixed in the form of sandwich by a metal frame for tight seal of the inside and for securement of rigidity of the module, and a space between the supporting substrate and the frame is sealed tightly with a sealant. If a flexible material is used as the cell itself, or as the supporting substrate, the filling material and the sealant, a solar battery can be constituted also on a curved surface. In the case of a solar battery using a flexible support such as a polymer film and the like, a battery body can be fabricated by forming cells sequentially while feeding a support in the form of a roll, cutting into a desired size, then, sealing a peripheral part with a flexible moisture-proof material. Also, a module structure called "SCAF" described in Solar Energy Materials and Solar Cells, 48, p 383-391 can be adopted. Further, a solar battery using a flexible support can also be adhered and fixed to curved glass and the like and used.

EXAMPLES

Examples for illustrating the present invention further in detail will be shown below, but the present invention is not limited to them.

Reference Example 1 (Synthesis of compound 2)

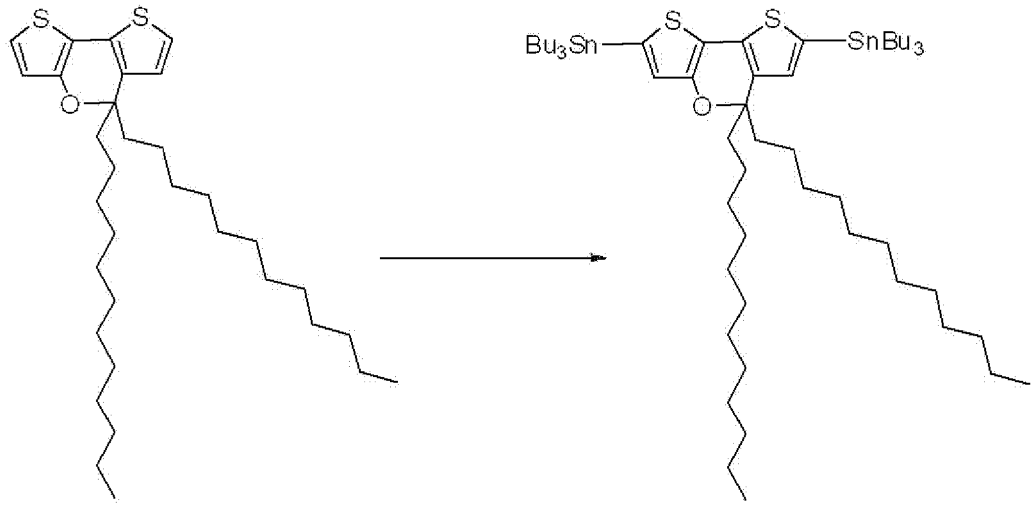

compound 1 compound 2

Into a 200 mL flask prepared by purging a gas in the flask with argon were charged 2.00 g (3.77 mmol) of a compound 1 synthesized according to a description of WO2011/052709 and 100 mL of dehydrated tetrahydrofuran and a uniform solution was obtained. While keeping the solution at -78°, 5.89 mL (9.42 mmol) of a 1. 6 M n-butyllithium hexane solution was dropped into the solution over a period of 10 minutes. After completion of dropping, the reaction liquid was stirred at -78°C for 30 minutes, then, stirred at room temperature (25°C) for 2 hours. Thereafter, the flask was cooled down to -78°C, and 3.37 g (10.4 mmol) of tributyltin chloride was added to the reaction liquid. After addition, the reaction liquid was stirred at -78°C for 30 minutes, then, stirred at room temperature (25°C) for 3 hours. Thereafter, to the reaction liquid was added 200 ml of water to stop the reaction, ethyl acetate was added and the reaction product was extracted. The organic layer was dried over sodium sulfate, and the solvent was distilled off by an evaporator. The resultant oily substance was purified by a silica gel column using hexane as a developing solvent, to obtain 3.55 g (3.20 mmol) of a compound 2. As the silica gel in the silica gel column, silica gel prepared by previously immersing in hexane containing 10 wt% of triethylamine for 5 minutes, then, rinsing with hexane was used

Example 1 (Synthesis of polymer compound A)

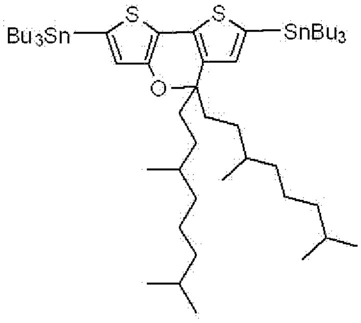

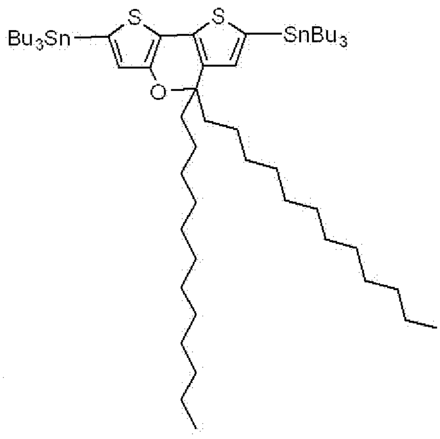

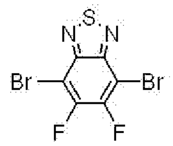

compound 3 compound 2 compound 4

Into a 300 mL flask prepared by purging a gas in the flask with argon were charged 800 mg (0.760 mmol) of a compound 3 synthesized according to a description of WO2011/052709, 840 mg (0.757 mmol) of the compound 2, 471 mg (1.43mmol) of a compound 4 synthesized according to a description of WO2011/052709 and 107 ml of toluene and a uniform solution was obtained. The resultant toluene solution was bubbled with argon for 30 minutes, then, to the toluene solution were added 19.6 mg (0.0214 mmol) of tris(dibenzylideneacetone)dipalladium and 39.1 mg (0.128 mmol) of tris(2-toluyl)phosphine, and the mixture was stirred at 100°C for 6 hours. Then, to the reaction liquid was added 660 mg of phenyl bromide, and the mixture was further stirred for 5 hours. Thereafter, the flask was cooled down to 25°C, and the reaction liquid was poured into 2000 mL of methanol. The deposited polymer was collected by filtration, the resultant polymer was placed into a cylindrical paper filter, and extracted with methanol, acetone and hexane, each for 5 hours, using a Soxhlet extractor. The polymer remaining in the cylindrical paper filter was dissolved in 53 mL of o-dichlorobenzene, 1.21 g of sodium diethyldithiocarbamate and 12 mL of water were added, and the mixture was stirred under reflux for 8 hours. After removal of the aqueous layer, the organic layer was washed with 200 ml of water twice, then, washed with 200 mL of a 3 wt% acetic acid aqueous solution twice, then, washed with 200 mL of water twice, and the resultant solution was poured into methanol to cause deposition of a polymer. The polymer obtained by filtration and drying was dissolved again in 62 mL of o-dichlorobenzene, and allowed to pass through an alumina/silica gel column. The resultant solution was poured into methanol to cause deposition of a polymer, which was filtrated and dried to obtain 802 mg of a purified polymer. Hereinafter, this polymer is referred to as a polymer compound A.

Example 2 (Fabrication and evaluation of organic film solar battery)

A glass substrate carrying thereon an ITO film having a thickness of 150 nm formed by a sputtering method was irradiated with ultraviolet using an UV ozone washing apparatus, thereby attaining surface treatment. Next, the polymer compound A and fullerene C60PCBM (phenyl C61-butyric acid methyl ester, manufactured by Frontier Carbon Corporation) were dissolved in ortho-dichlorobenzene so that the ratio of the weight of C60PCBM to the weight of the polymer compound A was 3, to produce an ink 1. Based on the weight of the ink 1, the sum of the weight of the polymer compound A and the weight of C60PCBM was 2.0 wt%. The ink 1 was coated on the glass substrate by spin coating, to fabricate an organic film containing the polymer compound A. The thickness of the organic film was about 100 nm. The organic film showed a measured value of light absorption terminal wavelength of 890 nm. Thereafter, lithium fluoride was vapor-deposited with a thickness of 2 nm on the organic film, then, Al was vapor-deposited with a thickness of 100 nm, by a vacuum vapor deposition machine, thereby fabricating an organic film solar battery. The shape of the resultant organic film solar battery was 2 mmx2 mm square. The resultant organic film solar battery was irradiated with constant light using Solar Simulator (manufactured by Bunkoukeiki Co., Ltd., trade name: OTENTO-SUNII: AM 1.5G filter, irradiance: 100 mW/cm$^2$), the generated current and voltage were measured, and the photoelectric conversion efficiency, the short-circuit current density, the open voltage and the fill factor were calculated. Jsc (short circuit current density) was14.5 mA/cm$^2$, Voc (open circuit voltage) was 0.71V, ff (fill factor) was 0.66 and the photoelectric conversion efficiency ($\eta$) was 6.76%.

Example 3 (Fabrication and evaluation of organic film solar battery)

An organic film solar battery was fabricated in the same manner as in Example 2 excepting that fullerene C70PCBM ([6,6] phenyl C71-butyric acid methyl ester, manufactured by Frontier Carbon Corporation) was used instead of fullerene C60PCBM, and the photoelectric conversion efficiency, the short circuit current density, the open circuit voltage and the fill factor were measured. The organic film showed a light absorption terminal wavelength of 890 nm. Jsc (short circuit current density) was 18.1 mA/$cm^2$, Voc (open circuit voltage) was 0.69V, ff (fill factor) was 0.67 and the photoelectric conversion efficiency ($\eta$) was 8.31%.

Reference Example 2 (Synthesis of compound 6)

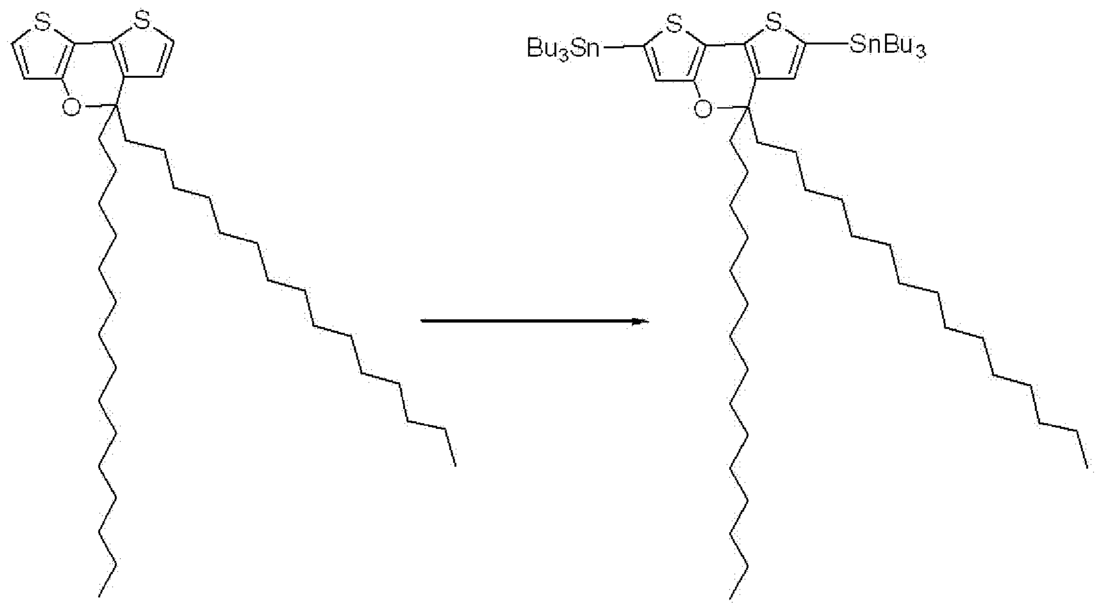

compound 5 compound 6

Into a 200 mL flask prepared by purging a gas in the flask with argon were charged 5.00 g (8.13 mmol) of a compound 5 synthesized according to a description of WO2011/052709 and 150 mL of dehydrated tetrahydrofuran and a uniform solution was obtained. Into the solution kept at -78°C, 12.7 mL (20.3 mmol) of a 1.6 M n-butyllithium hexane solution was dropped over a period of 10 minutes. After completion of dropping, the reaction liquid was stirred at -78°C for 30 minutes, then, stirred at room temperature (25°C) for 2 hours. Thereafter, the flask was cooled down to -78°C, and to the reaction liquid was added 7.28 g (22.3 mmol) of tributyltin chloride. After addition, the reaction liquid was stirred at -78°C for 30 minutes, then, stirred at room temperature (25°C) for 3 hours. Thereafter, to the reaction liquid was added 300 ml of water to stop the reaction, ethyl acetate was added and the reaction product was extracted. The organic layer was dried over anhydrous sodium sulfate, and the solvent was distilled off by an evaporator. The resultant oily substance was purified by a silica gel column using hexane as a developing solvent, to obtain 9.42 g (7.90 mmol) of a compound 6. As the silica gel in the silica gel column, silica gel prepared by previously immersing in hexane containing 10 wt% of triethylamine for 5 minutes, then, rinsing with hexane was used.

Example 4 (Synthesis of polymer compound B)

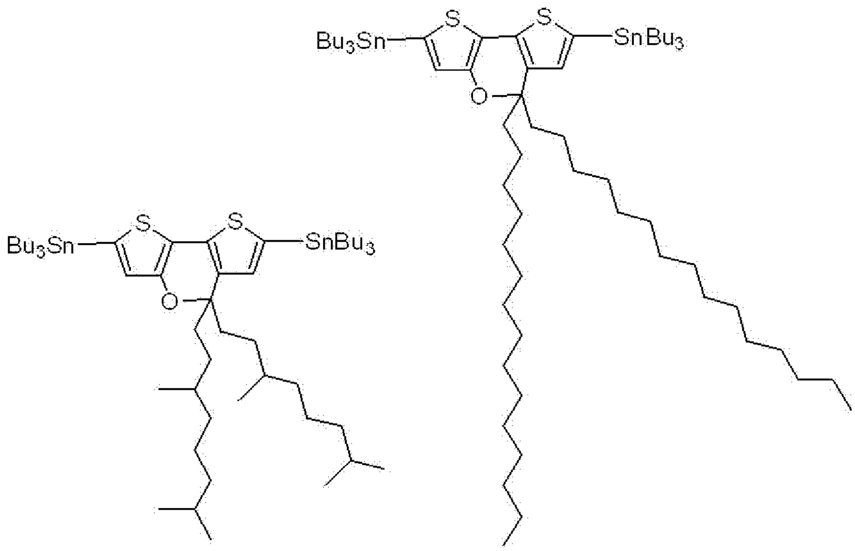

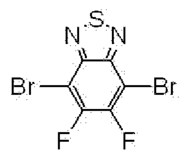

compound 3 compound 6 compound 4

Into a 200 mL flask prepared by purging a gas in the flask with argon were charged 205.8 mg (0.195 mmol) of a compound 3 synthesized according to a description of WO2011/052709, 233.1 mg (0.195 mmol) of the compound 6, 123 mg (0.373 mmol) of a compound 4 synthesized according to a description of WO2011/052709 and 29 ml of toluene and a uniform solution was obtained. The resultant toluene solution was bubbled with argon for 30 minutes, then, 5.12 mg (0.0056 mmol) of tris(dibenzylideneacetone)dipalladium and 10.2 mg (0.034 mmol) of tris(2-toluyl)phosphine were added, and the mixture was stirred at 100°C for 6 hours. Then, to the reaction liquid was added 133 mg of phenyl bromide, and the mixture was further stirred for 5 hours. Thereafter, the flask was cooled down to 25°C, and the reaction liquid was poured into 500 mL of methanol. The deposited polymer was collected by filtration, the resultant polymer was placed into a cylindrical paper filter, and extracted with methanol, acetone and hexane, each for 5 hours, using a Soxhlet extractor. The polymer remaining in the cylindrical paper filter was dissolved in 15 mL of o-dichlorobenzene, 0.31 g of sodium diethyldithiocarbamate and 3 mL of water were added, and the mixture was stirred under reflux for 8 hours. After removal of the aqueous layer, the organic layer was washed with 50 ml of water twice, then, washed with 50 mL of a 3 wt% acetic acid aqueous solution twice, then, washed with 50 mL of water twice, and the resultant solution was poured into methanol to cause deposition of a polymer. The polymer obtained by filtration and drying was dissolved again in 17 mL of o-dichlorobenzene, and allowed to pass through an alumina/silica gel column. The resultant solution was poured into methanol to cause deposition of a polymer, which was filtrated and dried, to obtain 188 mg of a purified polymer. Hereinafter, this polymer is referred to as a polymer compound B.

Example 5 (Fabrication and evaluation of organic film solar battery)

An organic film solar battery was fabricated in the same manner as in Example 2 excepting that the polymer compound B was used instead of the polymer compound A, and the photoelectric conversion efficiency, the short circuit current density, the open circuit voltage and the fill factor were measured. The organic film showed a light absorption terminal wavelength of 890 nm. Jsc (short circuit current density) was 11.9 mA/cm$^2$, Voc (open circuit voltage) was 0.70V, ff (fill factor) was 0.70 and the photoelectric conversion efficiency ($\eta$) was 5.83%.

Reference Example 3 (Synthesis of polymer compound C)

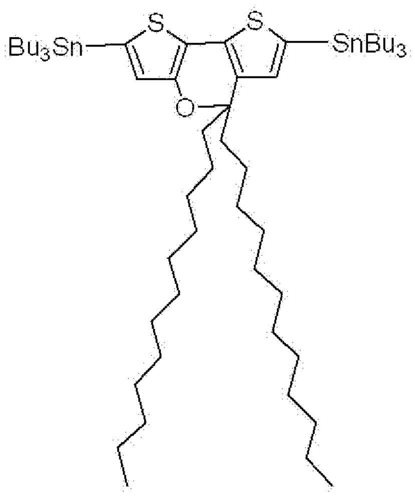

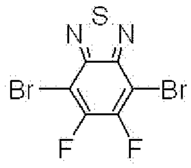

compound 2 compound 4

Into a 100 mL flask prepared by purging a gas in the flask with argon were charged 320 mg (0.289 mmol) of the compound 2, 100 mg (0.303 mmol) of a compound 4 synthesized according to a description of WO2011/052709 and 22 ml of toluene and a uniform solution was obtained. The resultant toluene solution was bubbled with argon for 30 minutes, then, 4.16 mg (0.0045 mmol) of tris(dibenzylideneacetone)dipalladium and 8.30 mg (0.027 mmol) of tris(2-toluyl)phosphine were added, and the mixture was stirred at 100°C for 6 hours. Then, to the reaction liquid was added 88.6 mg of phenyltrimethyltin, and the mixture was stirred for 5 hours, then, to the reaction liquid was added 500 mg of phenyl bromide, and the mixture was further stirred for 5 hours. Thereafter, the flask was cooled down to 25°C, and the reaction liquid was poured into 500 mL of methanol. The deposited polymer was collected by filtration, the resultant polymer was placed into a cylindrical paper filter, and extracted with methanol, acetone and hexane, each for 5 hours, using a Soxhlet extractor. The polymer remaining in the cylindrical paper filter was dissolved in 15 mL of o-dichlorobenzene, 0.31 g of sodium diethyldithiocarbamate and 3 mL of water were added, and the mixture was stirred under reflux for 8 hours. After removal of the aqueous layer, the organic layer was washed with 50 ml of water twice, then, washed with 50 mL of a 3 wt% acetic acid aqueous solution twice, then, washed with 50 mL of water twice, and the resultant solution was poured into methanol to cause deposition of a polymer. The polymer obtained by filtration and drying was dissolved again in 20 mL of o-dichlorobenzene, and allowed to pass through an alumina/silica gel column. The resultant solution was poured into methanol to cause deposition of a polymer, which was filtrated and dried, to obtain 174 mg of a purified polymer. Hereinafter, this polymer is referred to as a polymer compound C.

Comparative Example 1 (Fabrication and evaluation of organic film solar battery)

An organic film solar battery was fabricated in the same manner as in Example 2 excepting that the polymer compound C was used instead of the polymer compound A, and the photoelectric conversion efficiency, the short circuit current density, the open circuit voltage and the fill factor were measured. The organic film showed a light absorption terminal wavelength of 890 nm. Jsc (short circuit current density) was 10.5 $mA/cm^2$, Voc (open circuit voltage) was 0.69V, ff (fill factor) was 0.65 and the photoelectric conversion efficiency ($\eta$) was 4.72%.

Reference Example 4 (Synthesis of polymer compound D)

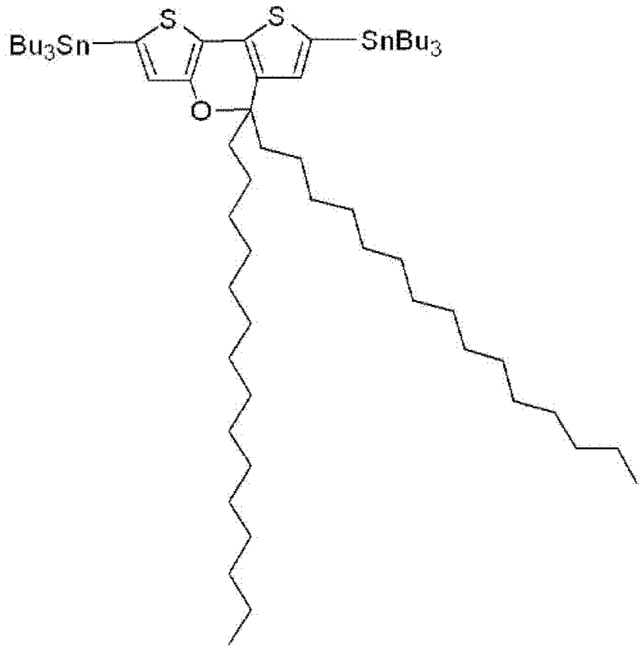

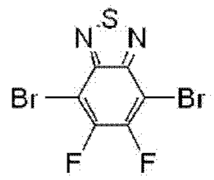

compound 6 compound 4

Into a 100 mL flask prepared by purging a gas in the flask with argon were charged 344 mg (0.288 mmol) of the compound 6 synthesized in the above-described Reference Example 2, 100 mg (0.303 mmol) of a compound 4 synthesized according to a description of WO2011/052709 and 23 ml of toluene and a uniform solution was obtained. The resultant toluene solution was bubbled with argon for 30 minutes, then, 4.16 mg (0.0045 mmol) of tris(dibenzylideneacetone)dipalladium and 8.30 mg (0.027 mmol) of tris(2-toluyl)phosphine were added, and the mixture was stirred at 100°C for 6 hours. Then, to the reaction liquid was added 90.0 mg of phenyltrimethyltin, and the mixture was further stirred for 5 hours, then, to the reaction liquid was added 500 mg of phenyl bromide, and the mixture was further stirred for 5 hours. Thereafter, the flask was cooled down to 25°C, and the reaction liquid was poured into 500 mL of methanol. The deposited polymer was collected by filtration, the resultant polymer was placed into a cylindrical paper filter, and extracted with methanol, acetone and hexane, each for 5 hours, using a Soxhlet extractor. The polymer remaining in the cylindrical paper filter was dissolved in 15 mL of o-dichlorobenzene, 0.3 g of sodium diethyldithiocarbamate and 3 mL of water were added, and the mixture was stirred under reflux for 8 hours. After removal of the aqueous layer, the organic layer was washed with 50 ml of water twice, then, washed with 50 mL of a 3 wt% acetic acid aqueous solution twice, then, washed with 50 mL of water twice, and the resultant solution was poured into methanol to cause deposition of a polymer. The polymer obtained by filtration and drying was dissolved again in 23 mL of o-dichlorobenzene, and allowed to pass through an alumina/silica gel column. The resultant solution was poured into methanol to cause deposition of a polymer, which was filtrated and dried to obtain 208 mg of a purified polymer. Hereinafter, this polymer is referred to as a polymer compound D.

Comparative Example 2 (Fabrication and evaluation of organic film solar battery)

An organic film solar battery was fabricated in the same manner as in Example 2 excepting that the polymer compound D was used instead of the polymer compound A, and the photoelectric conversion efficiency, the short circuit current density, the open circuit voltage and the fill factor were measured. The organic film showed a light absorption terminal wavelength of 890 nm. Jsc (short circuit current density) was 7.23 mA/cm$^2$, Voc (open circuit voltage) was 0.59V, ff (fill factor) was 0.64 and the photoelectric conversion efficiency ($\eta$) was 2.74%.

Reference Example 5 (Synthesis of polymer compound E)

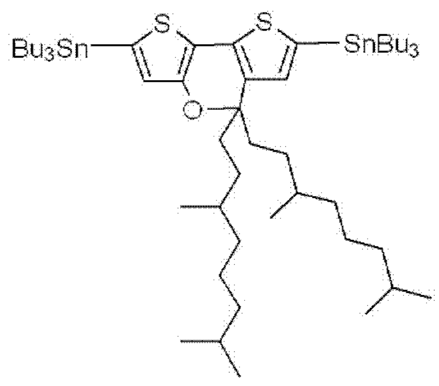

compound 3

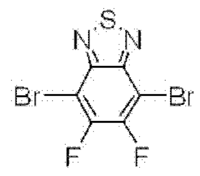

compound 4

Into a 200 mL flask prepared by purging a gas in the flask with argon were charged 500 mg (0.475 mmol) of a compound 3 synthesized according to a description of WO2011/052709, 141 mg (0.427 mmol) of a compound 4 synthesized according to a description of WO2011/052709 and 32 ml of toluene and a uniform solution was obtained. The resultant toluene solution was bubbled with argon for 30 minutes, then, 6.52 mg (0.007 mmol) of tris(dibenzylideneacetone)dipalladium and 13.0 mg of tris (2-toluyl) phosphine were added, and the mixture was stirred at 100°C for 6 hours. Then, to the reaction liquid was added 500 mg of phenyl bromide, and the mixture was further stirred for 5 hours. Thereafter, the flask was cooled down to 25°C, and the reaction liquid was poured into 300 mL of methanol. The deposited polymer was collected by filtration, the resultant polymer was placed into a cylindrical paper filter, and extracted with methanol, acetone and hexane, each for 5 hours, using a Soxhlet extractor. The polymer remaining in the cylindrical paper filter was dissolved in 100 mL of toluene, 2 g of sodium diethyldithiocarbamate and 40 mL of water were added, and the mixture was stirred under reflux for 8 hours. After removal of the aqueous layer, the organic layer was washed with 50 ml of water twice, then, washed with 50 mL of a 3 wt% acetic acid aqueous solution twice, washed with 50 mL of water twice, further, washed with 50 mL of a 5 wt% potassium fluoride aqueous solution twice, finally, washed with 50 mL of water twice, and the resultant solution was poured into methanol to cause deposition of a polymer. The polymer obtained by filtration and drying was dissolved again in 50 mL of o-dichlorobenzene, and allowed to pass through an alumina/silica gel column. The resultant solution was poured into methanol to cause deposition of a polymer, which was filtrated and dried, to obtain 185 mg of a purified polymer. Hereinafter, this polymer is referred to as a polymer compound E.

Comparative Example 3 (Fabrication and evaluation of organic film solar battery)

An organic film solar battery was fabricated in the same manner as in Example 2 excepting that the polymer compound E was used instead of the polymer compound A, and the photoelectric conversion efficiency, the short circuit current density, the open circuit voltage and the fill factor were measured. The organic film showed a light absorption terminal wavelength of 890 nm. Jsc (short circuit current density) was 12.2 $mA/cm^2$, Voc (open circuit voltage) was 0.71V, ff (fill factor) was 0.64 and the photoelectric conversion efficiency ($\eta$) was 5.54%.

Example 6 (Synthesis of polymer compound F)

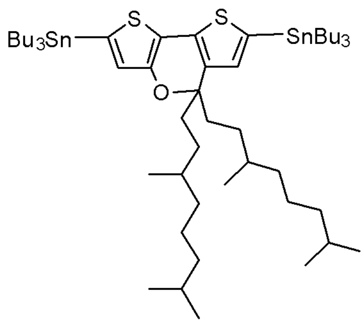 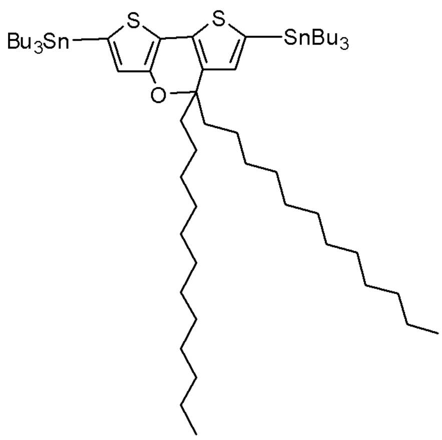 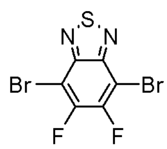

compound 3 compound 2 compound 4

Into a 300 mL flask prepared by purging a gas in the flask with argon were charged 936 mg (0.889 mmol) of the compound 3, 656.8 mg (0.592 mmol) of the compound 2, 515.0 mg (1.56 mmol) of the compound 4 and 106 ml of toluene and a uniform solution was obtained. The resultant toluene solution was bubbled with argon for 30 minutes, then, 21.44 mg (0.0234 mmol) of tris(dibenzylideneacetone)dipalladium and 42.76 mg (0.141 mmol) of tris(2-toluyl)phosphine were added, and the mixture was stirred at 100°C for 5 hours. To the reaction liquid was added 2824 mg of phenyl bromide, and the mixture was further stirred for 5 hours. Thereafter, the flask was cooled down to 25°C, and the reaction liquid was poured into 2000 mL of methanol. The deposited polymer was collected by filtration, the resultant polymer was placed into a cylindrical paper filter, and extracted with methanol, acetone and hexane, each for 5 hours, using a Soxhlet extractor. The polymer remaining in the cylindrical paper filter was dissolved in 53 mL of o-dichlorobenzene, 1.32 g of sodium diethyldithiocarbamate and 13 mL of water were added, and the mixture was stirred under reflux for 8 hours. After removal of the aqueous layer, the organic layer was washed with 200 ml of water twice, then, washed with 200 mL of a 3 wt% acetic acid aqueous solution twice, washed with 200 mL of water twice, and the resultant solution was poured into methanol to cause deposition of a polymer. The polymer obtained by filtration and drying was dissolved again in 60 mL of o-dichlorobenzene, and allowed to pass through an alumina/silica gel column. The resultant solution was poured into methanol to cause deposition of a polymer, which was filtrated and dried, to obtain 919 mg of a purified polymer. Hereinafter, this polymer is referred to as a polymer compound F.

Example 7 (Fabrication and evaluation of organic film solar battery)

An organic film solar battery was fabricated in the same manner as in Example 2 excepting that the polymer compound F was used instead of the polymer compound A, and the photoelectric conversion efficiency, the short circuit current density, the open circuit voltage and the fill factor were measured. The organic film showed a light absorption terminal wavelength of 890 nm. Jsc (short circuit current density) was 13.2 mA/cm$^2$, Voc (open circuit voltage) was 0.71V, ff (fill factor) was 0.63 and the photoelectric conversion efficiency ($\eta$) was 5.89%.

Example 8 (Synthesis of polymer compound G)

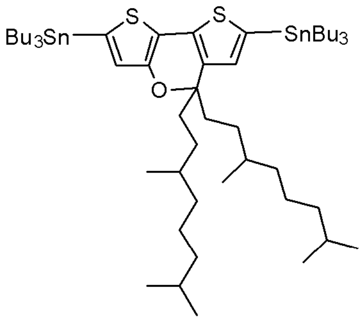

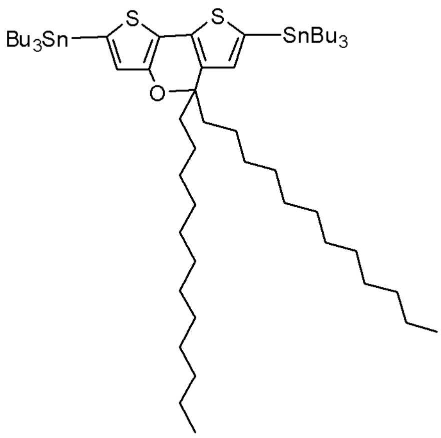

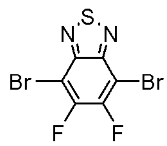

compound 3 compound 2 compound 4

Into a 300 mL flask prepared by purging a gas in the flask with argon were charged 624 mg (0.593 mmol) of the compound 3, 985.2 mg (0.888 mmol) of the compound 2, 515.0 mg (1.56 mmol) of the compound 4 and 107 ml of toluene and a uniform solution was obtained. The resultant toluene solution was bubbled with argon for 30 minutes, then, 21.44 mg (0.0234 mmol) of tris(dibenzylideneacetone)dipalladium and 42.8 mg (0.141 mmol) of tris(2-toluyl)phosphine were added, and the mixture was stirred at 100°C for 5 hours. To the reaction liquid was added 2824 mg of phenyl bromide, and the mixture was further stirred for 5 hours. Thereafter, the flask was cooled down to 25°C, and the reaction liquid was poured into 2000 mL of methanol. The deposited polymer was collected by filtration, the resultant polymer was placed into a cylindrical paper filter, and extracted with methanol, acetone and hexane, each for 5 hours, using a Soxhlet extractor. The polymer remaining in the cylindrical paper filter was dissolved in 53 mL of o-dichlorobenzene, 1.32 g of sodium diethyldithiocarbamate and 13 mL of water were added, and the mixture was stirred under reflux for 8 hours. After removal of the aqueous layer, the organic layer was washed with 200 ml of water twice, then, washed with 200 mL of a 3 wt% acetic acid aqueous solution twice, washed with 200 mL of water twice, and the resultant solution was poured into methanol to cause deposition of a polymer. The polymer obtained by filtration and drying was dissolved again in 60 mL of o-dichlorobenzene, and allowed to pass through an alumina/silica gel column. The resultant solution was poured into methanol to cause deposition of a polymer, which was filtrated and dried, to obtain 941 mg of a purified polymer. Hereinafter, this polymer is referred to as a polymer compound G.

Example 9 (Fabrication and evaluation of organic film solar battery)

An organic film solar battery was fabricated in the same manner as in Example 2 excepting that the polymer compound G was used instead of the polymer compound A, and the photoelectric conversion efficiency, the short circuit current density, the open circuit voltage and the fill factor were measured. The organic film showed a light absorption terminal wavelength of 890 nm. Jsc (short circuit current density) was 13.5 mA/cm$^2$, Voc (open circuit voltage) was 0.71V, ff (fill factor) was 0.66 and the photoelectric conversion efficiency ($\eta$) was 6.27%.

Reference Example 6 (Synthesis of compound 8)

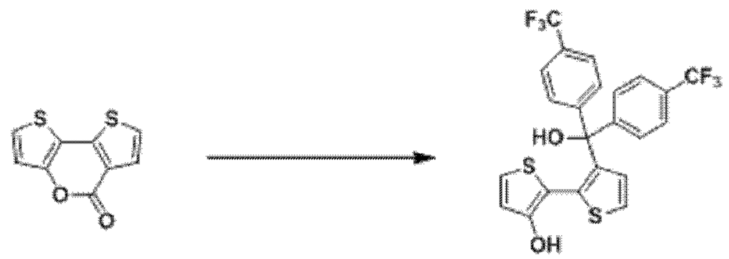

compound 7 compound 8

Into a 300 mL four-necked flask prepared by purging air in the flask with nitrogen were charged 3.12 g (15.0 mmol) of a compound 7 synthesized according to a description of WO2011/052709 and 150 mL of dehydrated THF and a uniform solution was obtained, and cooled down to -25 °C in a dry ice acetone bath. Into this, 15 mL (50 mmol) of a p-trifluoromethylphenylmagnesium bromide tetrahydrofuran solution was dropped, and the mixture was stirred at -25°C for 10 minutes. Then, the mixture was heated up to room temperature over a period of 30 minutes and stirred at room temperature for 2 hours. Thereafter, the flask was cooled down to 0°C, and 100 mL of water was slowly added to stop the reaction. The aqueous layer was made acidic using acetic acid, then, the product was extracted with ethyl acetate, and the organic layer was washed with 50 mL of water three times. The resultant organic layer was dried over anhydrous magnesium sulfate, then, and the solvent was distilled off under reduced pressure, to obtain 7.21 g of a compound 8 as brown liquid.

Reference Example 7 (Synthesis of compound 9)

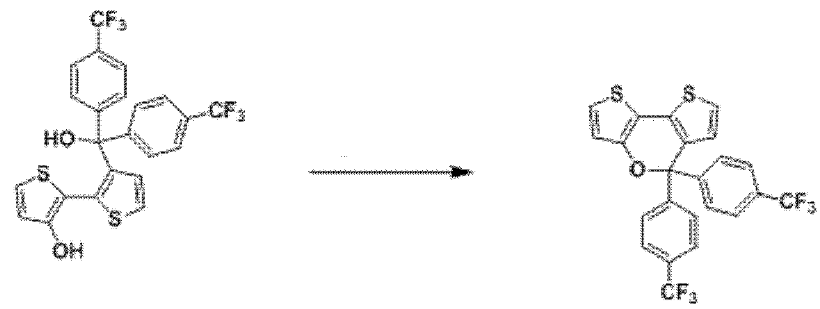

compound 8 compound 9

Into a 300 mL four-necked flask prepared by purging air in the flask with nitrogen were charged 7.21 g (14.4 mmol) of the compound 8 synthesized in the above-described Reference Example 6, 0.49 g (2.60 mmol) of p-toluenesulfonic acid and 100 mL of dehydrated toluene and a uniform solution was obtained. The resultant solution was immersed in an oil bath of 120°C and stirred under reflux with heating for 3 hours. Thereafter, the flask was cooled, the organic layer was extracted with toluene, and the organic layer was washed with 50 mL of water three times. The resultant organic layer was dried over anhydrous magnesium sulfate, and the solvent was distilled off under reduced pressure. The resultant oily coarse product was purified by silica gel column chromatography (developing solvent, hexane:chloroform = 10:1 (vol:vol)), to obtain 5.60 g (11.1 mmol) of a compound 9.

Reference Example 8 (Synthesis of compound 10)

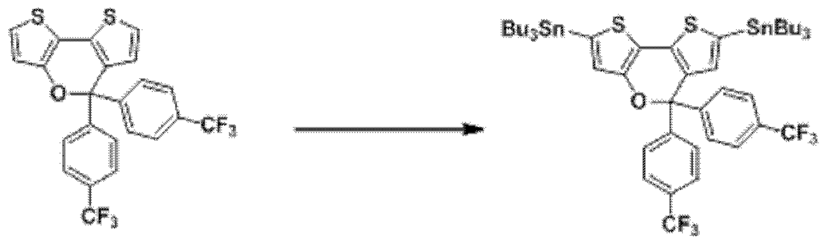

compound 9 compound 10

Into a 300 mL flask prepared by purging air in the flask with nitrogen were charged 2.41 g (5.00 mmol) of the compound 9 synthesized in the above-described Reference Example 7 and 90 mL of dehydrated THF and a uniform solution was obtained. The resultant solution was cooled down to -78°C in a dry ice acetone bath and into this, 7.19 mL (11.5 mmol) of a n-butyllithium hexane solution (1.6M) was dropped. After dropping, the mixture was stirred at -78°C for about 30 minutes, then, heated up to room temperature and stirred for 2 hours and 30 minutes. Thereafter, the mixture was cooled down to -78°C again, and 4.07 g (12.5 mmol ) of tributyltin chloride ($Bu_3$ SnCl) was added. The mixture was stirred at -78°C for 1 hour, then, heated up to room temperature and further stirred for 2 hours. Thereafter, 50 mL of water was added to stop the reaction, extraction with ethyl acetate was performed, and the organic layer was washed with 50 mL of water three times. The resultant organic layer was dried over anhydrous magnesium sulfate, and the solvent was distilled off under reduced pressure. The resultant oily coarse product was purified by silica gel column chromatography (developing solvent: hexane). As the silica gel in the silica gel column, silica gel prepared by previously immersing in hexane containing 10 wt% of triethylamine for 5 minutes, then, rinsing with hexane was used. Then, the product was purified by reverse phase silica gel column chromatography (methanol:acetone = 1:1), to obtain 4.70 g (4.40 mmol) of a compound 10.

Example 10 (Synthesis of polymer compound H)

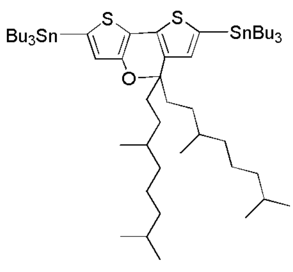 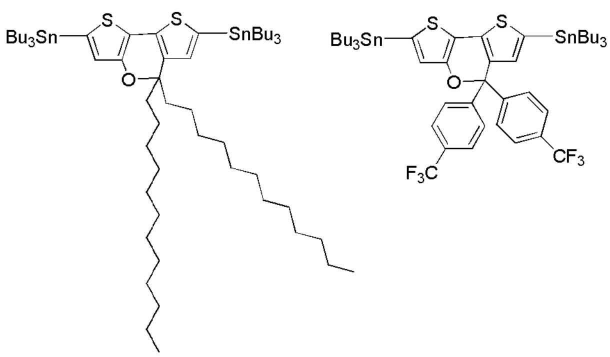 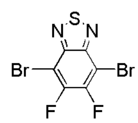

compound 3 compound 2 compound 10 compound 4

Into a 300 mL flask prepared by purging a gas in the flask with argon were charged 288 mg (0.274 mmol) of the compound 3, 303.8 mg (0.274 mmol) of the compound 2, 64 mg (0.060 mmol) of the compound 10 synthesized in the above-described Reference Example 8, 210 mg (636 mmol) of the compound 4 and 41 ml of toluene and a uniform solution was obtained. The resultant toluene solution was bubbled with argon for 30 minutes, then, 8.74 mg (0.0095 mmol) of tris(dibenzylideneacetone)dipalladium and 17.4 mg (0.057 mmol) of tris (2-toluyl) phosphine were added, and the mixture was stirred at 100°C for 5 hours. Then, to the reaction liquid was added 472 mg of phenyl bromide, and the mixture was further stirred for 5 hours. Thereafter, the flask was cooled down to 25°C, and the reaction liquid was poured into 1000 mL of methanol. The deposited polymer was collected by filtration, the resultant polymer was placed into a cylindrical paper filter, and extracted with methanol, acetone and hexane, each for 5 hours, using a Soxhlet extractor. The polymer remaining in the cylindrical paper filter was dissolved in 21 mL of o-dichlorobenzene, and 0.54 g of sodium diethyldithiocarbamate and 5 mL of water were added, and the mixture was stirred under reflux for 8 hours. After removal of the aqueous layer, the organic layer was washed with 200 ml of water twice, then, washed with 200 mL of a 3 wt% acetic acid aqueous solution twice, washed with 200 mL of water twice, and the resultant solution was poured into

methanol to cause deposition of a polymer. The polymer obtained by filtration and drying was dissolved again in 47 mL of o-dichlorobenzene, and allowed to pass through an alumina/silica gel column. The resultant solution was poured into methanol to cause deposition of a polymer, which was filtrated and dried, to obtain 345 mg of a purified polymer. Hereinafter, this polymer is referred to as a polymer compound H.

Example 11 (Fabrication and evaluation of organic film solar battery)

An organic film solar battery was fabricated in the same manner as in Example 2 excepting that the polymer compound H was used instead of the polymer compound A, and the photoelectric conversion efficiency, the short circuit current density, the open circuit voltage and the fill factor were measured. The organic film showed a light absorption terminal wavelength of 890 nm. Jsc (short circuit current density) was 14.3 $mA/cm^2$, Voc (open circuit voltage) was 0.73V, ff (fill factor) was 0.60 and the photoelectric conversion efficiency ($\eta$) was 6.29%.

Table 1

| Results of evaluation of organic film solar battery | | | | | |
|---|---|---|---|---|---|
| | fullerene | short circuit current density ($mA/cm^2$) | open circuit voltag e (V) | fill factor | photoelectric conversion efficiency (%) |
| Example 2 | C60PCBM | 14.5 | 0.71 | 0.66 | 6.76 |
| Example 3 | C70PCBM | 18.1 | 0.69 | 0.67 | 8.31 |
| Example 5 | C60PCBM | 11.9 | 0.70 | 0.70 | 5.83 |
| Example 7 | C60PCBM | 13.2 | 0.71 | 0.63 | 5.89 |
| Example 9 | C60PCBM | 13.5 | 0.71 | 0.66 | 6.27 |
| Example 11 | C60PCBM | 14.3 | 0.73 | 0.60 | 6.29 |
| Comparative Example 1 | C60PCBM | 10.5 | 0.69 | 0.65 | 4.72 |
| Comparative Example 2 | C60PCBM | 7.23 | 0.59 | 0.64 | 2.74 |
| Comparative Example 3 | C60PCBM | 12.2 | 0.71 | 0.64 | 5.54 |

Industrial Applicability

An organic photoelectric conversion device having an organic layer containing the compound of the present invention manifests large photoelectric conversion efficiency, that is, the present invention is extremely useful.

## Claims

**1.** A polymer compound comprising a constituent unit represented by the formula (1) and a constituent unit represented by the formula (2):

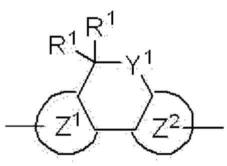

(1)

wherein $R^1$ represents a branched alkyl group; $Y^1$ represents an oxygen atom, a sulfur atom or $-N(R^3)-$; $R^3$ represents a hydrogen atom or a substituent; ring $Z^1$ and ring $Z^2$ represent each independently an optionally substituted aromatic carbocyclic ring or an optionally substituted heterocyclic ring;

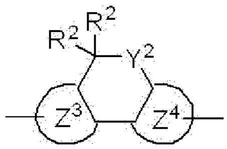

(2)

wherein $R^2$ is different from $R^1$ and represents a linear alkyl group; $Y^2$ represents an oxygen atom, a sulfur atom or $-N(R^3)-$; $R^3$ represents a hydrogen atom or a substituent; ring $Z^3$ and ring $Z^4$ represent each independently an optionally substituted aromatic carbocyclic ring or an optionally substituted heterocyclic ring.

**2.** The compound according to Claim 1, wherein the number of carbon atoms of $R^1$ and the number of carbon atoms of $R^2$ are each independently 10 to 15.

**3.** The polymer compound according to Claim 1, further comprising a constituent unit represented by the formula (3) :

$-Ar^1-$ (3)

wherein $Ar^1$ is different from the constituent unit represented by the formula (1) and the constituent unit represented by the formula (2) and represents an optionally substituted arylene group or a divalent heterocyclic group.

**4.** The polymer compound according to Claim 3, wherein $Ar^1$ is a constituent unit represented by the formulae (3-1) to (3-8):

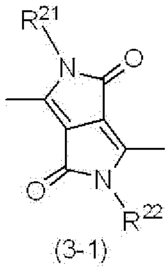

(3-1)

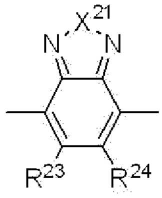

(3-2)

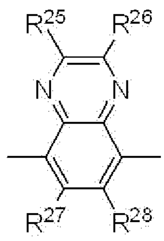

(3-3)

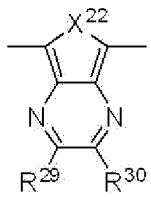

(3-4)

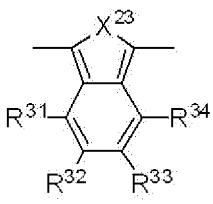

(3-5)

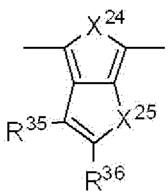

(3-6)

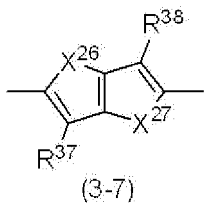

(3-7)

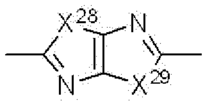

(3-8)

in the formulae (3-1) to (3-8), $R^{21}$ to $R^{38}$ represent each independently a hydrogen atom or a substituent. $X^{21}$ to $X^{29}$ represent each independently a sulfur atom, an oxygen atom or a selenium atom.

**5.** The polymer compound according to Claim 1, wherein the polystyrene-equivalent number-average molecular weight is 3000 or more.

**6.** A composition comprising the polymer compound according to any one of Claims 1 to 5 and an electron accepting compound.

**7.** The composition according to Claim 6, wherein the electron accepting compound is a fullerene derivative.

**8.** A film comprising the polymer compound according to any one of Claims 1 to 5 or the composition according to Claim 6.

**9.** An ink comprising the composition according to Claim 6 and a solvent.

**10.** An electronic device comprising the polymer compound according to any one of Claims 1 to 5; or an organic film transistor comprising a gate electrode, a source electrode, a drain electrode and an active layer, wherein the active layer comprises the polymer compound according to any one of Claims 1 to 5.

**11.** An organic photoelectric conversion device comprising a first electrode , a second electrode, and an active layer between the first electrode and the second electrode, wherein the active layer comprises the polymer compound according to any one of Claims 1 to 5.

**12.** A solar battery module or image sensor comprising the organic photoelectric conversion device according to Claim 11.

**Patentansprüche**

**1.** Eine Polymerverbindung, umfassend eine Komponenteneinheit dargestellt durch die Formel (1) und eine Komponenteneinheit dargestellt durch die Formel (2):

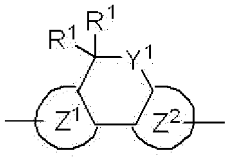

(1)

wobei $R^1$ eine verzweigte Alkylgruppe darstellt; $Y^1$ ein Sauerstoffatom, ein Schwefelatom oder $-N(R^3)-$ darstellt; $R^3$ ein Wasserstoffatom oder einen Substituenten darstellt; Ring $Z^1$ und Ring $Z^2$ jeweils unabhängig einen gegebenenfalls substituierten aromatischen carbocyclischen Ring oder einen gegebenenfalls substituierten heterocyclischen Ring darstellen;

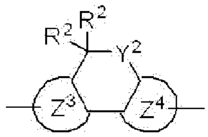

(2)

wobei $R^2$ sich von $R^1$ unterscheidet und eine lineare Alkylgruppe darstellt; $Y^2$ ein Sauerstoffatom, ein Schwefelatom oder $-N(R^3)-$ darstellt; $R^3$ ein Wasserstoffatom oder einen Substituenten darstellt; Ring $Z^3$ und Ring $Z^4$ jeweils unabhängig einen gegebenenfalls substituierten aromatischen carbocyclischen Ring oder einen gegebenenfalls substituierten heterocyclischen Ring darstellen.

**2.** Die Verbindung gemäß Anspruch 1, wobei die Anzahl der Kohlenstoffatome von $R^1$ und die Anzahl der Kohlenstoffatome von $R^2$ jeweils unabhängig 10 bis 15 betragen.

**3.** Die Polymerverbindung gemäß Anspruch 1, ferner umfassend eine Komponenteneinheit dargestellt durch die Formel (3):

$-Ar^1-$ (3)

wobei $Ar^1$ sich von der Komponenteneinheit, dargestellt durch die Formel (1), und der Komponenteneinheit, dargestellt durch die Formel (2), unterscheidet und eine gegebenenfalls substituierte Arylengruppe oder eine zweiwertige heterocyclische Gruppe darstellt.

**4.** Die Polymerverbindung gemäß Anspruch 3, wobei $Ar^1$ eine Komponenteneinheit ist, dargestellt durch die Formeln (3-1) bis (3-8):

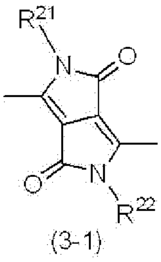
(3-1)

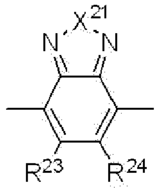
(3-2)

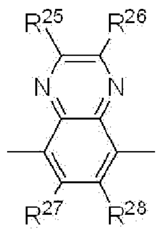
(3-3)

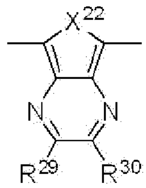
(3-4)

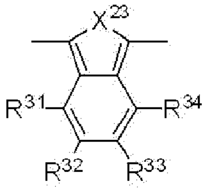
(3-5)

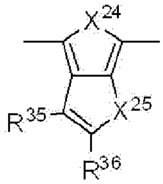
(3-6)

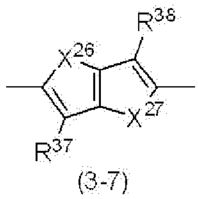
(3-7)

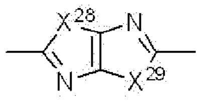
(3-8)

wobei, in den Formeln (3-1) bis (3-8), $R^{21}$ bis $R^{38}$ jeweils unabhängig ein Wasserstoffatom oder einen Substituenten darstellen. $X^{21}$ bis $X^{29}$ stellen jeweils unabhängig ein Schwefelatom, ein Sauerstoffatom oder ein Selenatom dar.

**5.** Die Polymerverbindung gemäß Anspruch 1, wobei das Polystyrol-äquivalente Zahlenmittel des Molekulargewichts 3000 oder mehr beträgt.

**6.** Eine Zusammensetzung, umfassend die Polymerverbindung gemäß einem der Ansprüche 1 bis 5 und eine elektronenaufnehmende Verbindung.

**7.** Die Zusammensetzung gemäß Anspruch 6, wobei die elektronenaufnehmende Verbindung ein Fullerenderivat ist.

**8.** Eine Folie, umfassend die Polymerverbindung gemäß einem der Ansprüche 1 bis 5 oder die Zusammensetzung gemäß Anspruch 6.

**9.** Eine Tinte, umfassend die Zusammensetzung gemäß Anspruch 6 und ein Lösungsmittel.

**10.** Eine elektronische Vorrichtung, umfassend die Polymerverbindung gemäß einem der Ansprüche 1 bis 5; oder einen organischen Folientransistor, umfassend eine Gate-Elektrode, eine Quellenelektrode, eine Drain-Elektrode und eine aktive Schicht, wobei die aktive Schicht die Polymerverbindung gemäß einem der Ansprüche 1 bis 5 umfasst.

**11.** Eine organische photoelektrische Umwandlungsvorrichtung, umfassend eine erste Elektrode, eine zweite Elektrode und eine aktive Schicht zwischen der ersten Elektrode und der zweiten Elektrode, wobei die aktive Schicht die Polymerverbindung gemäß einem der Ansprüche 1 bis 5 umfasst.

**12.** Ein Solarbatteriemodul oder Bildsensor, umfassend die organische photoelektrische Umwandlungsvorrichtung gemäß Anspruch 11.

**Revendications**

**1.** Composé polymère comprenant un motif constitutif représenté par la formule (1) et un motif constitutif représenté par la formule (2) :

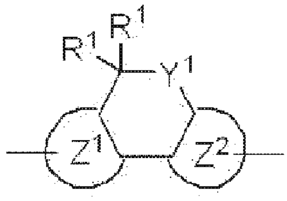

(1)

dans laquelle $R^1$ représente un groupe alkyle ramifié ; $Y^1$ représente un atome d'oxygène, un atome de soufre ou $-N(R^3)-$ ; $R^3$ représente un atome d'hydrogène ou un substituant ; le cycle $Z^1$ et le cycle $Z^2$ représentent chacun indépendamment un cycle carbocyclique aromatique éventuellement substitué ou un cycle hétérocyclique éventuellement substitué ;

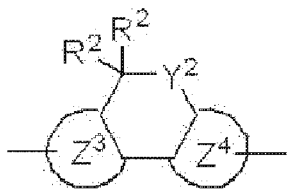

(2)

dans laquelle $R^2$ est différent de $R^1$ et représente un groupe alkyle linéaire ; $Y^2$ représente un atome d'oxygène, un atome de soufre ou $-N(R^3)-$ ; $R^3$ représente un atome d'hydrogène ou un substituant ; le cycle $Z^3$ et le cycle $Z^4$ représentent chacun indépendamment un cycle carbocyclique aromatique éventuellement substitué ou un cycle hétérocyclique éventuellement substitué.

2. Composé selon la revendication 1, dans lequel le nombre d'atomes de carbone de $R^1$ et le nombre d'atomes de carbone de $R^2$ sont chacun indépendamment de 10 à 15.

3. Composé polymère selon la revendication 1, comprenant en outre un motif constitutif représenté par la formule (3) :

$-Ar^1-$ (3)

dans laquelle $Ar^1$ est différent du motif constitutif représenté par la formule (1) et du motif constitutif représenté par la formule (2) et représente un groupe arylène éventuellement substitué ou un groupe hétérocyclique divalent.

4. Composé polymère selon la revendication 3, dans lequel Ar est un motif constitutif représenté par les formules (3-1) à (3-8) suivantes :

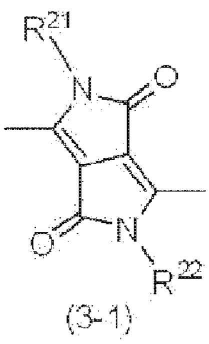

(3-1)

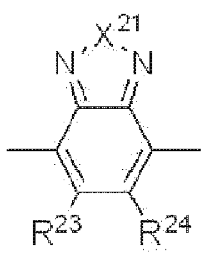

(3-2)

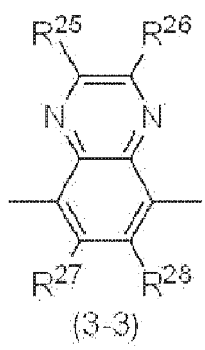

(3-3)

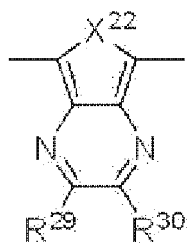

(3-4)

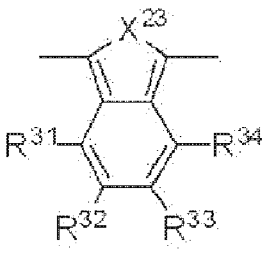

(3-5)

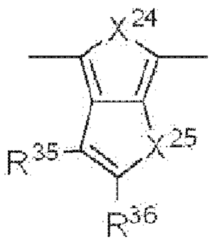

(3-6)

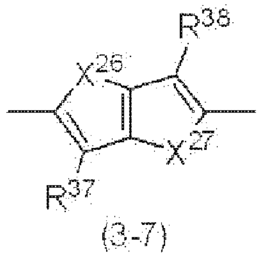

(3-7)

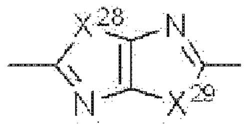

(3-8)

dans les formules (3-1) à (3-8), $R^{21}$ à $R^{38}$ représentent chacun indépendamment un atome d'hydrogène ou un substituant, $X^{21}$ à $X^{29}$ représentent chacun indépendamment un atome de soufre, un atome d'oxygène ou un atome de sélénium.

**5.** Composé polymère selon la revendication 1, dans lequel le poids moléculaire moyen en nombre équivalent au polystyrène est de 3000 ou plus.

**6.** Composition comprenant le composé polymère selon l'une quelconque des revendications 1 à 5 et un composé accepteur d'électrons.

**7.** Composition selon la revendication 6, dans laquelle le composé accepteur d'électrons est un dérivé de fullerène.

**8.** Film comprenant le composé polymère selon l'une quelconque des revendications 1 à 5 ou la composition selon la revendication 6.

**9.** Encre comprenant la composition selon la revendication 6 et un solvant.

**10.** Dispositif électronique comprenant le composé polymère selon l'une quelconque des revendications 1 à 5 ; ou transistor à film organique comprenant une électrode de grille, une électrode de source, une électrode de drain et une couche active, dans lequel la couche active comprend le composé polymère selon l'une quelconque des revendications 1 à 5.

**11.** Dispositif de conversion photoélectrique organique comprenant une première électrode, une seconde électrode, et une couche active entre la première électrode et la seconde électrode, dans lequel la couche active comprend le composé polymère selon l'une quelconque des revendications 1 à 5.

**12.** Module de batterie solaire ou capteur d'image comprenant le dispositif de conversion photoélectrique organique selon la revendication 11.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2011052709 A
- US 2011114183 A
- WO 2011052710 A


### Non-patent literature cited in the description


- *Solar Energy Materials and Solar Cells,* vol. 48, 383-391